(19) Europäisches Patentamt
European Patent Office
Office européen des brevets

(11) **EP 4 757 555 A1**

(12) **EUROPEAN PATENT APPLICATION**
published in accordance with Art. 153(4) EPC

(43) Date of publication:
**10.06.2026 Bulletin 2026/24**

(21) Application number: **24852235.1**

(22) Date of filing: **02.08.2024**

(51) International Patent Classification (IPC):
**H10K 59/121** (2023.01)  **H10K 71/20** (2023.01)
**H10K 59/122** (2023.01)  **H10K 59/35** (2023.01)
**H10K 59/80** (2023.01)  **H10K 59/12** (2023.01)

(52) Cooperative Patent Classification (CPC):
**H10K 59/12; H10K 59/121; H10K 59/122;
H10K 59/35; H10K 59/80; H10K 71/20**

(86) International application number:
**PCT/KR2024/011446**

(87) International publication number:
**WO 2025/033881 (13.02.2025 Gazette 2025/07)**

(84) Designated Contracting States:
**AL AT BE BG CH CY CZ DE DK EE ES FI FR GB
GR HR HU IE IS IT LI LT LU LV MC ME MK MT NL
NO PL PT RO RS SE SI SK SM TR**
Designated Extension States:
**BA**
Designated Validation States:
**GE KH MA MD TN**

(30) Priority: **04.08.2023  KR 20230102412
09.11.2023  KR 20230154628
11.06.2024  KR 20240075900
17.07.2024  KR 20240094563**

(71) Applicants:
• **Yas Co., Ltd.**
**Paju-si, Gyeonggi-do 10857 (KR)**
• **Ahn, Byungchul**
**Seoul 06574 (KR)**

(72) Inventor: **AHN, Byungchul**
**Seoul 06574 (KR)**

(74) Representative: **Epping - Hermann - Fischer
Patentanwaltsgesellschaft mbH
Schloßschmidstraße 5
80639 München (DE)**

(54) **ORGANIC LIGHT-EMITTING DISPLAY DEVICE**

(57)     An organic light-emitting display device may include a bank between subpixels on a substrate, an anode electrode on the subpixel, an organic light-emitting layer disposed on the anode electrode and the bank and comprising a hole injection layer, a cathode electrode disposed on the organic light-emitting layer and being in contact with an end of the hole injection layer, and an open structure in an edge region of the bank. The organic light-emitting layer may have a separation structure corresponding to the open structure, and the hole injection layer may be isolated in the separation structure.

FIG. 4A

**Description**

[Technical Field]

The embodiment relates to an organic light-emitting display device.

[Background Art]

As the demand for portable information media increases, an attempt to apply an organic light-emitting display device to various lightweight and thin information electronic devices is expanding. Recently, the organic light-emitting display device is being applied to product groups such as a mobile PC and an automobile rather than TV or a mobile phone. Since the organic light-emitting display device applied to the mobile PC and the automobile is driven as still image for a long time, long lifespan is required. In order to have the long lifespan, the extraction of light from the organic light-emitting element must be maximized. In addition, in order to reduce the cost, it is necessary to expand the technology to be able to produce organic light-emitting elements on a substrate 110 of not only 8.5th generation (2200x2,500mm) but also 10.5th generation (3370x2940mm). In order to produce long-lifespan organic light-emitting element, each subpixel with a top emission structure and a side-by-side structure must be implemented as a structure of an organic light-emitting element with two or more stacks.

The structure of such an organic light-emitting element can be obtained by using a deposition equipment using a fine metal mask (FMM, hereinafter referred to as FMM). However, the deposition method using FMM has the problem of low productivity because the production logistics must be produced only in a cluster method rather than an in-line method. In addition, there is a problem of low pixel position accuracy (PPA) between the FMM and the substrate. Accordingly, the emission region ratio (EAR) is small, which limits the product life. Here, the emission region ratio is the value obtained by dividing the emission region of the subpixel by the area of the subpixel.

Therefore, the development of a new deposition method to solve the aforementioned problems and an organic light-emitting display device having a new organic light-emitting element structure using the new deposition method is very urgent.

[Disclosure]

[Technical Problem]

An object of the embodiment is to solve the foregoing and other problems.

Another object of the embodiment is to provide an organic light-emitting display device having a novel structure.

Another object of the embodiment is to provide an organic light-emitting display device capable of improving the lifespan.

Another object of the embodiment is to provide an organic light-emitting display device capable of improving productivity and yield.

Another object of the embodiment is to provide an organic light-emitting display device capable of improving image quality.

The technical problems of the embodiments are not limited to those described in this item and comprise those that can be understood through the description of the invention.

[Technical Solution]

In order to achieve the above or other objects, according to one aspect of the embodiment, an organic light-emitting display device, comprising: a bank between subpixels on a substrate; an anode electrode in the subpixel; an organic light-emitting layer disposed on the anode electrode and the bank, and comprising a hole injection layer; a cathode electrode disposed on the organic light-emitting layer and being in contact with an end of the hole injection layer; and an open structure in an edge region of the bank, wherein the organic light-emitting layer has a separation structure corresponding to the open structure, and wherein the hole injection layer is configured to be isolated in the separation structure.

The open structure may comprise at least one or more blocking layer which is inwardly recessed from a side portion of the bank.

The open structure has an undercut structure having a blocking gap corresponding to a width of the blocking layer. A margin of the blocking gap may be set between a distance between a cathode electrode and a second organic light-emitting stack in a red organic light-emitting element having the largest thickness and a distance between an anode electrode and a cathode electrode in a blue organic light-emitting element having the smallest thickness.

A thickness of the blocking gap may be set based on a deposition simulation experiment and an actual deposition experiment based on a method of setting the blocking gap calculated from a thickness of the organic light-emitting element for each color.

The organic light-emitting layer may comprise a first organic light-emitting stack between the hole injection layer and a charge generation layer; and a second organic light-emitting stack between the charge generation layer and the cathode electrode. The cathode electrode may be in contact with an end of the charge generation layer.

The first organic light-emitting stack and the charge generation layer may be isolated in the separation structure.

The cathode electrode may comprise at least one of a first conductive layer or a second conductive layer. The first conductive layer may comprise a Mg:Ag alloy, and the second conductive layer may comprise a conductive oxide material.

The organic light-emitting display device may further comprise a protrusion part on an upper side of the bank. The protrusion part has a connection structure comprising an auxiliary electrode electrically connected to the cathode electrode. The protrusion part may comprise a first layer; and a second layer on the first layer. The connection structure may have an undercut structure in which is recessed from a side portion of the second layer into the inside of the protrusion part.

The second conductive layer may be disposed on the first conductive layer, the first conductive layer may be disposed on the organic light-emitting layer, and the second conductive layer may be in contact with a side portion of the first layer and a lower side of the second layer.

The protrusion part further may comprise a third layer below the first layer. A side portion of the third layer may be positioned on the same line as the side portion of the second layer or extends in a direction of the subpixel from the side portion of the second layer.

At least one of the first layer, the second layer or the third layer may be the auxiliary electrode.

The hole injection layer may be disposed on the third layer, and the first conductive layer may be in contact with the end of the hole injection layer and an upper side of the third layer.

The second conductive layer may be disposed on the first conductive layer, the first conductive layer may be disposed on the organic light-emitting layer, and the second conductive layer may be in contact with the side portion of the first layer, the lower side of the second layer, the end of the hole injection layer and an upper side of the third layer.

The protrusion part further may comprise a fourth layer on the second layer.

[Advantageous Effects]

The effects of the organic light-emitting display device according to the embodiment are described as follows.

According to at least one of the embodiments, there is an advantage that the process is simplified and the process cost can be reduced because there is no need to use an FMM.

According to at least one of the embodiments, there is an advantage that the EAR in the subpixel is increased because there is no need to use an FMM, so that the lifespan can be improved.

According to at least one of the embodiments, there is an advantage that productivity, yield, and material utilization efficiency can be improved by depositing the organic light-emitting element on a large-area substrate in an in-line deposition system.

Additional scope of applicability of the embodiments will become apparent from the detailed description that follows. However, since various changes and modifications within the idea and scope of the embodiments may be clearly understood by those skilled in the art, the detailed description and specific embodiments, such as preferred embodiments, should be understood as being given by way of example only.

[Description of Drawings]

FIG. 1 is a schematic plan view of an organic light-emitting display device according to a first embodiment.

FIG. 2 is a plan view illustrating one pixel of FIG. 1.

FIG. 3 is a circuit diagram illustrating an organic light-emitting display device according to the embodiment.

FIG. 4A is a cross-sectional view taken along line A-A' of the pixel of FIG. 2.

FIG. 4B is a cross-sectional view taken along line B-B' of the pixel of FIG. 2.

FIG. 4C is a cross-sectional view taken along line C-C' of the pixel of FIG. 2.

FIG. 5 is a cross-sectional view of an organic light-emitting display device according to the first embodiment.

FIG. 6 is a cross-sectional view of an organic light-emitting display device according to a second embodiment.

FIG. 7 is a cross-sectional view of an organic light-emitting display device according to a third embodiment.

FIG. 8A is a cross-sectional view illustrating an organic light-emitting display device according to a fourth embodiment.

FIG. 8B is a cross-sectional view illustrating a connection structure in the asymmetric open-connection structure of FIG. 8A.

FIG. 8C is a cross-sectional view illustrating an open structure in the asymmetric open-connection structure of FIG. 8A.

FIG. 9 illustrates an organic light-emitting element stacked in a two-stack structure in each subpixel according to an embodiment.

FIG. 10A is a cross-sectional view illustrating an organic light-emitting display device according to a fifth embodiment.

FIG. 10B is a cross-sectional view illustrating a connection structure in the asymmetric open-connection structure of FIG. 10A.

FIG. 10C is a cross-sectional view illustrating an open structure in the asymmetric open-connection structure of FIG. 10A.

FIG. 11 shows the deposition simulation results of a green organic light-emitting element deposited around an undercut structure of an open structure.

FIGS. 12A to 12G illustrate various protrusion parts.

FIGS. 13A to 13C show various placement positions of the open structure in the asymmetric open-connection structure according to the embodiment.

FIG. 14 is a cross-sectional view illustrating an organic light-emitting display device according to a sixth embodiment.

FIG. 15 is a cross-sectional view illustrating an organic light-emitting display device according to a seventh embodiment.

FIG. 16 is a cross-sectional view illustrating an organic light-emitting display device according to an eighth embodiment.

FIG. 17 is a cross-sectional view illustrating an organic light-emitting display device according to a ninth embodiment.

FIGS. 18A to 18D illustrate at least one or more layer additionally added between the electron injection layer and the cathode electrode of the second organic light-emitting stack.

FIGS. 19A to 19C show simulated results for luminance according to the thickness of a capping layer comprising LiF according to comparative examples and embodiments.

FIG. 20 is a plan view schematically illustrating an organic light-emitting display device according to the second embodiment.

FIG. 21 is a plan view illustrating one pixel of FIG. 20.

The sizes, shapes, dimensions, etc. of elements illustrated in the drawings can differ from actual ones. In addition, even if the same elements are illustrated in different sizes, shapes, dimensions, etc. between the drawings, this is only an example on the drawing, and the same elements have the same sizes, shapes, dimensions, etc. between the drawings.

[Mode for Invention]

Hereinafter, the embodiment disclosed in this specification will be described in detail with reference to the accompanying drawings, but the same or similar elements are given the same reference numerals regardless of reference numerals, and redundant descriptions thereof will be omitted. The suffixes 'module' and 'unit' for the elements used in the following descriptions are given or used interchangeably in consideration of ease of writing the specification, and do not themselves have a meaning or role that is distinct from each other. In addition, the accompanying drawings are for easy understanding of the embodiment disclosed in this specification, and the technical idea disclosed in this specification is not limited by the accompanying drawings. Also, when an element such as a layer, region or substrate is referred to as being 'on' another element, this means that there can be directly on the other element or be other intermediate elements therebetween.

Hereinafter, an organic light-emitting display device having a side-by-side structure manufactured using a photolithography process is disclosed. This structure is called Ph-SbS (side-by-side structure by photolithography). By using the photolithography process, the process can be simplified and the process cost can be reduced because there is no need to use FMM. In addition, the EAR within the subpixel can be increased, so that the lifespan can be improved. In addition, since the organic light-emitting element is deposited on a large-area substrate in an in-line deposition system, productivity, yield, and material utilization efficiency can be improved.

Hereinafter, the red subpixel SPr may be named the first subpixel, the green subpixel SPg may be named the second subpixel, and the blue subpixel SPb may be named the third subpixel. In addition, the red organic light-emitting element 120r may be named the first organic light-emitting element, the green organic light-emitting element 120g may be named the second organic light-emitting element, and the blue organic light-emitting element 120b may be named the third organic light-emitting element.

Hereinafter, the organic light-emitting display device 100 may be a top-emission type that displays an image by emitting light in the upper direction of the substrate 110, but a bottom-emission type that displays an image by emitting light in the lower direction of the substrate 110 may also be included in the technical idea of the present invention.

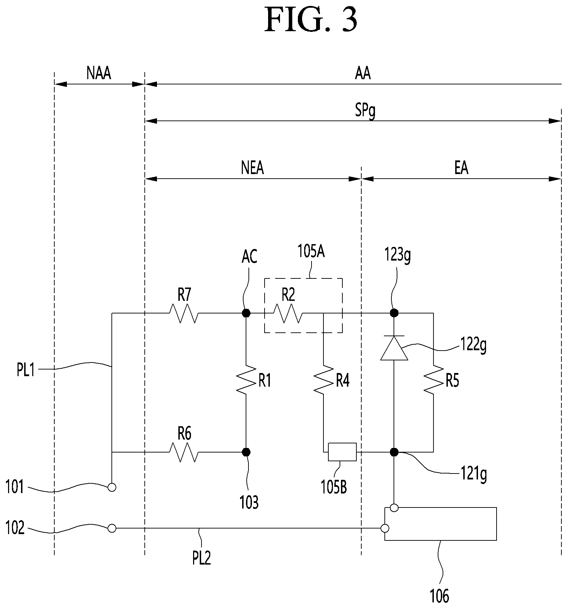

Hereinafter, the drawing number of the auxiliary electrode may be given as AC as illustrated in FIG. 3 unless a separate drawing number is given.

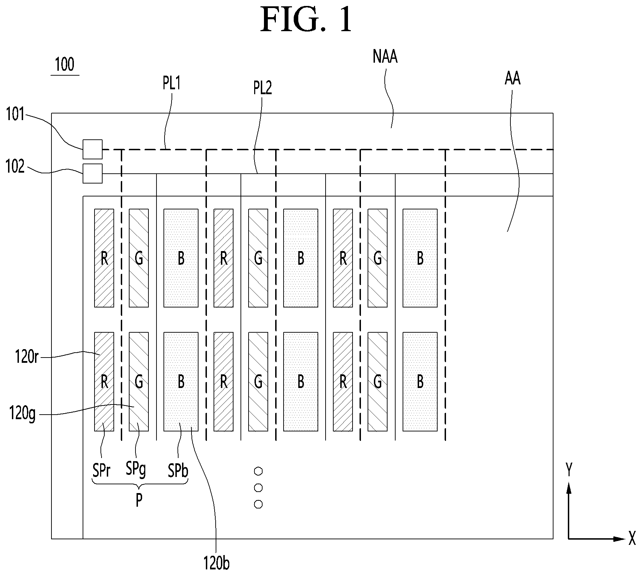

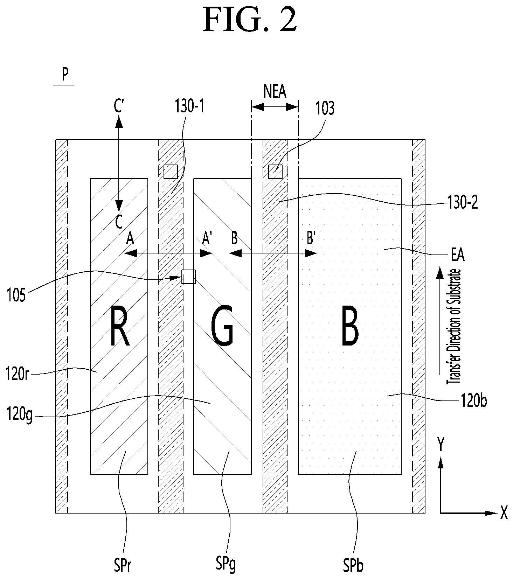

FIG. 1 is a plan view schematically illustrating an organic light-emitting display device according to a first embodiment. FIG. 2 is a plan view illustrating one pixel of FIG. 1.

Referring to FIGS. 1 and 2, the organic light-emitting display device 100 according to the first embodiment may comprise a plurality of pixels P arranged in a matrix. The plurality of pixels P may be positioned in a display region AA. The remaining area excluding the display region AA may be a non-display region NAA.

Each pixel P may comprise, for example, a red subpixel SPr, a green subpixel SPg, and a blue subpixel SPb. For example, a red organic light-emitting element 120r may be disposed in a red subpixel SPr, a green organic light-emitting element 120g may be disposed in a green subpixel SPg, and a blue organic light-emitting element 120b may be disposed in a blue subpixel SPb. Although one pixel P comprising three subpixels SPr, SPg, and SPb is illustrated in the drawing, more subpixels may be included than these.

Although the drawing illustrates that the area of the blue subpixel SPb is greater than the area of the red subpixel SPr or the area of the green subpixel SPg, other variations are possible.

Each of the subpixels SPr, SPg, and SPb may comprise an emission region EA and a non-emission region NEA. The emission region EA may be an area where the organic light-emitting element 120r, 120g, and 120b of each of the subpixels SPr, SPg, and SPb is disposed, and the non-emission region NEA may be the remaining area excluding the emission region EA in each of the subpixels SPr, SPg, and SPb.

Meanwhile, a first power line PL1 and a second power line PL2 may be provided to supply power to each of the subpixels SPr, SPg, and SPb. A first power terminal 101 may be electrically connected to one end of the first power line PL1, and a second power terminal 102 may be electrically connected to one end of the second power line PL2. The first power terminal 101 and the second power terminal 102 may be electrically connected to a power supply unit (not illustrated) to receive a first potential voltage and a second potential voltage. The second potential voltage is greater than the first potential voltage, and the first potential voltage can be grounded.

The first power line PL1 and the second power line PL2 can be disposed between the non-emission region NEA along a first direction X. The first power line PL1 and the second power line PL2 can be electrically connected to each of the subpixels SPr, SPg, and SPb.

A contact pad 103 can be positioned in the non-emission region NEA. The first power line PL1 can be electrically connected to the contact pad 103.

The auxiliary electrode (AC in FIG. 3) can be positioned in the non-emission region NEA. The auxiliary electrode AC can be positioned in the non-emission region NEA along a second direction Y, but is not limited thereto.

The auxiliary electrode AC can be positioned in the non-emission region NEA adjacent to each of the subpixels SPr, SPg, and SPb. The auxiliary electrode AC may be electrically connected to the first power line PL1 via the contact pad 103.

The first power line PL1, the contact pad 103, and the auxiliary electrode AC may be disposed in different layers.

The auxiliary electrode AC may be electrically connected to a cathode electrodes of the adjacent organic light-emitting elements 120r, 120g, and 120b of the adjacent subpixels SPr, SPg, and SPb. For example, when the auxiliary electrode AC is positioned between the red subpixel SPr and the green subpixel SPg, the auxiliary electrode AC may be electrically connected to the cathode electrode of the red organic light-emitting element 120r and the cathode electrode of the green organic light-emitting element 120g.

Therefore, the auxiliary electrode AC may supply the first potential voltage from the first power line PL1 to the cathode electrode of each of the organic light-emitting elements 120r, 120g, and 120b.

Meanwhile, the second power line PL2 may be electrically connected to a driving circuit 106 of each of the subpixels SPr, SPg, and SPb, for example, the driving transistor, but is not limited thereto. Accordingly, when a specific subpixel is selected in response to a scan signal provided through a specific gate line, light having a luminance corresponding to the current flowing in the driving transistor of the specific subpixel may be emitted by the first potential voltage of the first power line PL1 and the second potential voltage of the second power line PL2.

The plurality of organic light-emitting elements 120r, 120g, and 120b may be disposed in a stripe shape along the second direction Y. That is, the plurality of organic light-emitting elements 120r, 120g, and 120b may be disposed continuously without being separated along the second direction Y, respectively. For example, the red organic light-emitting elements 120r may be disposed continuously along the second direction Y, the green organic light-emitting elements 120g may be disposed continuously along the second direction Y, and the blue organic light-emitting elements 120b may be disposed continuously along the second direction Y.

As another example, the plurality of organic light-emitting elements 120r, 120g, and 120b may be separated into pixel P units or row-line units along the second direction Y. That is, the red organic light-emitting element 120r may be separated into pixel P units or row-line units along the second direction Y, the green organic light-emitting element 120g may be separated into pixel P units or row-line units along the second direction Y, and the blue organic light-emitting element 120b may be separated into pixel P units or row-line units along the second direction Y.

The red subpixels SPr, the green subpixels SPg, and the blue subpixels SPb may be alternately arranged into column-line units along the first direction X. That is, the red subpixel SPr, the green subpixel SPg, and the blue subpixel SPb having different colors may be sequentially positioned along the first direction X to implement an organic light-emitting display device having a side-by-side structure.

Meanwhile, an asymmetric open-connect (AOC) structure 105 may be positioned in the non-emission region NEA. In an embodiment, the asymmetric open-connection structure 105 may comprise a connection structure 105A and an open structure 105B. Due to the different ratios of depth and gap in the undercut structures of the connection structure 105A and the open structure 105B, it can be named as the asymmetric open-connection structure 105. The depth may represent a width in a horizontal direction of the undercut structure, and the gap may represent a width in a vertical direction of the undercut structure.

As will be described later, a lateral leakage current between a plurality of subpixels SPr, SPg, and SPb may be prevented by the asymmetric open-connection structure 105. The lateral leakage current may refer to a leakage current flowing between adjacent subpixels SPr, SPg, and SPb along the first direction X. In addition, an electrical short between the anode electrode and the cathode electrode in the corresponding subpixels SPr, SPg, and SPb may be prevented by the asymmetric open-connection structure 105. Therefore, by using the asymmetric open-connection structure 105, color spot due to leakage current may be enhanced and luminescence efficiency and luminance may be significantly improved.

The connection structure 105A may be a structure that electrically connects the auxiliary electrode AC to the cathode electrode of each of the organic light-emitting elements 120r, 120g, and 120b.

The open structure 105B may be a structure that separates layers comprising low-resistance organic light-emitting materials of each of the organic light-emitting elements 120r, 120g, and 120b, such as a hole injection layer, a charge generation layer, etc., thereby preventing electrical shorts between the anode electrode and the cathode electrode and reducing leakage current between sub-pixels. The asymmetric open-connection structure 105 may also be called a 'paradoxical open-connection structure.'

FIG. 3 is a circuit diagram illustrating an organic light-emitting display device according to an embodiment. FIG. 3 may be a circuit diagram for an electrical connection from the first power terminal 101 and the second power terminal 102 in FIG. 2 to the green subpixel SPg. The circuit diagram illustrated in FIG. 2 may be equally applied to a circuit diagram for an electrical connection from the first power terminal 101 and the second power terminal 102 to the red subpixel SPr or the blue subpixel SPb.

As illustrated in FIG. 3, the first power terminal 101 and the second power terminal 102 may be disposed in the non-display region NAA, and the first power line PL1 and the second power line PL2 may be disposed in the non-display region NAA and the display region AA.

The contact pad 103 may be disposed in the non-emission region NEA and may be electrically connected to the first power line PL1. The first power line PL1 may be electrically connected to the auxiliary electrode AC via the contact pad 103.

The organic light-emitting element 120g may be disposed in the emission region EA of the subpixel SPg, and the connection structure 105A and the open structure 105B may be disposed in the non-emission region NEA. The asymmetric open-connection structure 105 illustrated in FIG. 2 may be configured by the connection structure 105A and the open structure 105B. The auxiliary electrode AC can be electrically connected to the cathode electrode 123g of the organic light-emitting element 120g through the connection structure 105A. The hole injection layer of the organic light-emitting element 120g can be isolated through the open structure 105B, so that the anode electrode 121g and the cathode electrode 123g can be electrically disconnected.

As illustrated in FIG. 3, various resistances can be formed between each component. Each resistance can be defined as follows:

R1: Contact resistance between the contact pad 103 and the auxiliary electrode AC

R2: Resistance between the auxiliary electrode AC and the cathode electrode

R4: Resistance between the anode electrode 121g and the cathode electrode 123g due to the hole injection layer, etc., disposed in the horizontal direction

R5: Resistance between the anode electrode 121g and the cathode electrode 123g due to the plurality of organic light-emitting layers disposed in the vertical direction

R6: Resistance between the first power line PL1 and the contact pad 103

R7: Resistance between the first power line PL1 and the auxiliary electrode AC

Among the above-mentioned resistances, since the hole injection layer, etc., forming the fourth resistance R4 is made of a low-resistance organic light-emitting material, leakage current easily flows through the hole injection layer, etc. When leakage current flows through the hole injection layer, etc., the electrical short between the anode electrode 121g and the cathode electrode 123g may cause light not to be emitted from the corresponding subpixels SPr, SPg, and SPb, or the luminance of the light may be significantly lower than the desired luminance.

In an embodiment, the hole injection layer corresponding to the open structure 105B may be isolated by the open structure 105B, thereby blocking the leakage current flowing through the hole injection layer, etc.

In an embodiment, the cathode electrode 123g may be easily connected to the auxiliary electrode AC through the connection structure 105A, and the deposition area of the organic light-emitting element 120g may be maximized, thereby improving the luminescence efficiency.

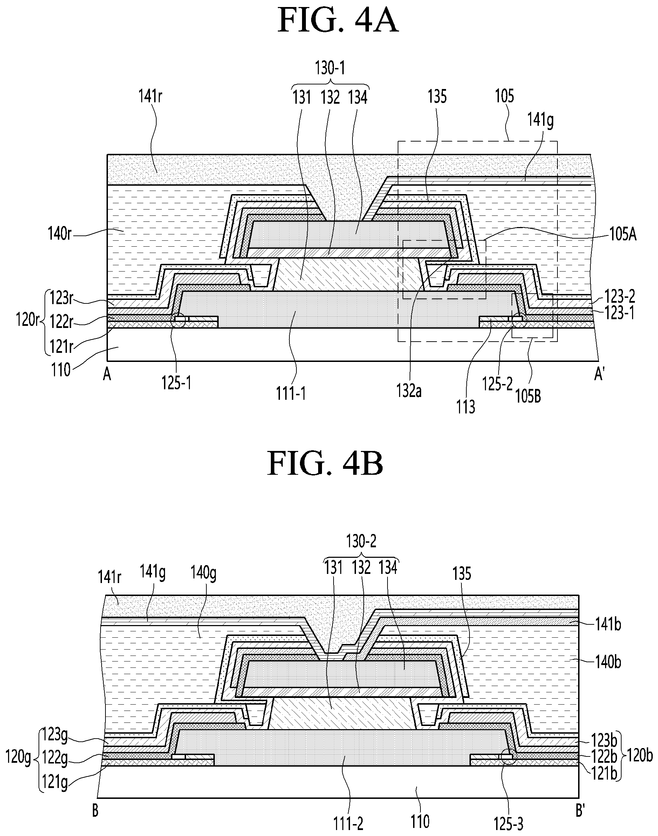

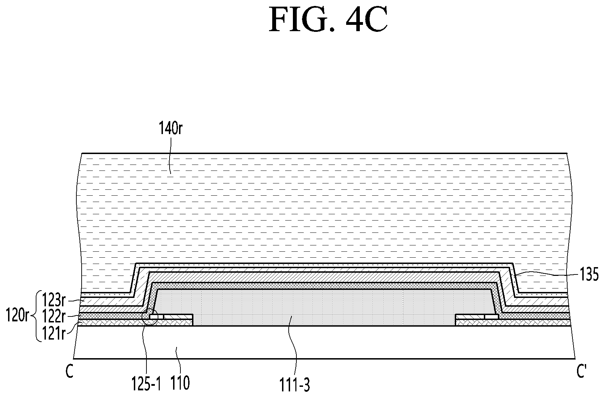

FIG. 4A is a cross-sectional view taken along the line A-A' in the pixel of FIG. 2. FIG. 4B is a cross-sectional view taken along the line B-B' in the pixel of FIG. 2. FIG. 4C is a cross-sectional view taken along the line C-C' in the pixel of FIG. 2.

Referring to FIG. 1, FIG. 2, and FIG. 4A to FIG. 4C, an organic light-emitting display device according to an embodiment may comprise a plurality of banks 111-1 and 111-2, a plurality of protrusion parts 130-1 and 130-2, a plurality of organic light-emitting elements 120r, 120g, and 120b, etc.

A plurality of banks 111-1 and 111-2, a plurality of protrusion parts 130-1 and 130-2, and a plurality of organic light-emitting elements 120r, 120g, and 120b may be disposed on a substrate 110. A plurality of banks 111-1 and 111-2, a plurality of protrusion parts 130-1 and 130-2, and/or a plurality of organic light-emitting elements 120r, 120g, and 120b may be disposed on the substrate 110 in a stripe shape along the second direction Y, respectively. In this instance, subpixels of the same color may be disposed along the second direction Y. For example, a plurality of red subpixels SPr may be disposed in a stripe shape along the second direction Y. The banks 111-1 and 111-2 may comprise an inorganic material or an organic material. For example, the banks 111-1 and 111-2 may comprise an inorganic material such as SiNx, SiON, etc.

Meanwhile, as illustrated in FIG. 4C, the transverse banks 111-3 may be disposed in a row-line unit along the second direction Y. Alternatively, the protrusion parts may not be disposed in a row-line unit along the second direction Y. That is, the protrusion part along the second direction Y may not be disposed on the transverse bank 111-3.

The first bank 111-1 and the second bank 111-2 may be called longitudinal banks to distinguish them from the transverse bank 111-3.

The plurality of subpixels SPr, SPg, and SPb may be separated from each other by the plurality of banks 111-1 and 111-2. The first bank 111-1 may be disposed between the red subpixel SPr and the green subpixel SPg, and the second bank 111-2 may be disposed between the green subpixel SPg and the blue subpixel SPb. Although not illustrated, the third bank may be disposed between the blue subpixel SPb and another red subpixel SPr.

The plurality of organic light-emitting elements 120r, 120g and 120b can be spatially separated and electrically isolated from each other by the plurality of banks 111-1 and 111-2. Accordingly, the lateral leakage current between the plurality of subpixels SPr, SPg and SPb can be blocked, thereby enhancing color spot and enhancing luminescence efficiency and luminance.

The red organic light-emitting element 120r can be disposed in the red subpixel SPr, the green organic light-emitting element 120g can be disposed in the green subpixel SPg, and the blue organic light-emitting element 120b can be disposed in the blue subpixel SPb.

The plurality of banks 111-1 and 111-2 can have a lattice shape. For example, the banks 111-1 and 111-2 can be disposed along the perimeter of the subpixel SPr, SPg and SPb. That is, the plurality of banks 111-1 and 111-2 may be disposed between the adjacent subpixels SPr, SPg and SPb along the first direction X, and between the adjacent subpixels SPr, SPg and SPb along the second direction Y. In this instance, the adjacent subpixels SPr, SPg and SPb along the first direction X may have different colors, while the adjacent subpixels SPr, SPg and SPb along the second direction Y may have the same color.

The plurality of organic light-emitting elements 120r, 120g and 120b may be separated from each other by the plurality of banks 111-1 and 111-2. The plurality of banks 111-1 and 111-2 may be disposed to distinguish the plurality of organic light-emitting elements 120r, 120g and 120b, respectively. The red organic light-emitting element 120r and the green organic light-emitting element 120g may be separated by the first bank 111-1, and the green organic light-emitting element 120g and the blue organic light-emitting element 120b may be separated by the second bank 111-2.

Meanwhile, the organic light-emitting display device according to the embodiment may comprise an open structure 105B in an edge region of each of the plurality of banks 111-1 and 111-2. For example, the open structure 105B may be disposed in an edge region of the lower side of each of the plurality of banks 111-1 and 111-2, but is not limited thereto.

The open structure 105B may be disposed in an edge region of the banks 111-1 and 111-2 between the subpixels SPr, SPg, and SPb along the first direction X. The open structure 105B may be disposed in the edge region of the banks 111-1 and 111-2 between the subpixels SPr, SPg, and SPb along the second direction Y.

When the organic light-emitting elements 120r, 120g, and 120b are deposited on the banks 111-1 and 111-2, some layers of the organic light-emitting elements 120r, 120g, and 120b may be isolated by the open structure 105B. For example, the open structure 105B may isolate the low-resistance layers of each of the organic light-emitting elements 120r, 120g, and 120b. The low-resistance layers may comprise, for example, a hole injection layer, a charge generation layer, etc. The low-resistance layer may mean a layer having a resistance value lower than the resistance value of a high-resistance layer, for example, an organic light-emitting layer, an electron transport layer, an electron injection layer, etc.

For example, the organic light-emitting layers 122r, 122g and 122b of the organic light-emitting elements 120r, 120g and 120b may have separation structures 125-1 to 125-3 corresponding to the open structures 105B. The separation structure 125-1 to 125-3 may mean a shape in which some layers of the organic light-emitting layers 122r, 122g and 122b are isolated. Accordingly, in the separation structure 125-1 to 125-3, for example, a hole injection layer, a charge generation layer, etc. may be isolated.

The open structure 105B may comprise at least one or more blocking layer 113 which is inwardly recessed from the side portions of the banks 111-1 and 111-2. An undercut structure may be formed in the edge regions of the banks 111-1 and 111-2 by the blocking layer 113. The blocking layer 113 may comprise a silicon-based inorganic material, a metal, etc. Aluminum (Al), molybdenum (Mo), a molybdenum alloy, etc. may be used as the metal, but are not limited thereto.

When organic light-emitting elements 120r, 120g and 120b are deposited on banks 111-1 and 111-2 where the undercut structure is formed in this way, some layers corresponding to the undercut structure, such as the hole injection layer and the charge generation layer, among the organic light-emitting layers 122r, 122g and 122b of the organic light-emitting elements 120r, 120g and 120b may be isolated.

Meanwhile, as described above, the organic light-emitting elements 120r, 120g and 120b corresponding to the subpixels SPr, SPg and SPb may be disposed, respectively.

The red organic light-emitting element 120r may comprise an anode electrode 121r, a red organic light-emitting layer 122r, a cathode electrode 123r, etc. The red organic light-emitting layer 122r may be disposed on the anode electrode 121r, and the cathode electrode 123r may be disposed on the red organic light-emitting layer 122r. The green organic light-emitting element 120g may comprise the anode electrode 121g, the green organic light-emitting layer 122g, the cathode electrode 123g, etc. The green organic light-emitting layer 122g may be disposed on the anode electrode 121g, and the cathode electrode 123g may be disposed on the green organic light-emitting layer 122g. The blue organic light-emitting element 120b may comprise the anode electrode 121b, the blue organic light-emitting layer 122b, the cathode electrode 123b, etc. The blue organic light-emitting layer 122b may be disposed on the anode electrode 121b, and the cathode electrode 123b may be disposed on the blue organic light-emitting layer 122b.

The anode electrode 121r, 121g and 121b may comprise a plurality of conductive layers. The anode electrode 121r, 121g and 121b may have a triple structure composed of ITO/Ag alloy/ITO. The anode electrode 121r, 121g and 121b may have a triple structure composed of ITO/Ag alloy/(Ti, Mo or MoTi).

One end of the anode electrode 121r, 121g and 121b may be disposed below the bank 111-1 and 111-2. That is, one end of the bank 111-1 and 111-2 may be disposed on one end of the anode electrode 121r, 121g and 121b. One end of the anode electrode 121r, 121g and 121b may be vertically overlapped with the bank 111-1 and 111-2.

The red organic light-emitting layer 122r, the green organic light-emitting layer 122g and the blue organic light-emitting layer 122b may comprise at least a hole injection layer comprising a low-resistance organic light-emitting material, respectively.

Meanwhile, one end of the hole injection layer and/or the charge generation layer may be in contact with the cathode electrode 123r, 123g and 123b. In addition, the lower surface of the hole injection layer may be in contact with the anode electrode 121r, 121g and 121b. In this instance, since the resistance of the hole injection layer is small, a leakage current may flow between the anode electrode 121r, 121g, and 121b and the cathode electrode 123r, 123g, and 123b, and an electrical short may occur between the anode electrode 121r, 121g, and 121b and the cathode electrode 123r, 123g, and 123b.

However, according to an embodiment, since the hole injection layer and/or the charge generation layer are isolated by the open structure 105B disposed in the edge region of the bank 111-1 and 111-2, the anode electrode 121r, 121g, and 121b and the cathode electrode 123r, 123g, and 123b may be electrically disconnected, so that an electrical short can be prevented.

Meanwhile, the organic light-emitting display device according to the embodiment may comprise a plurality of protrusion parts 130-1 and 130-2.

The plurality of organic light-emitting elements 120r, 120g and 120b may be spatially separated and electrically isolated from each other by the plurality of protrusion parts 130-1 and 130-2. Accordingly, the lateral leakage current between the plurality of subpixels SPr, SPg and SPb may be blocked, thereby improving color spot and enhancing light-emitting efficiency and luminance.

The plurality of protrusion parts 130-1 and 130-2 may be disposed on the upper sides of the plurality of banks 111-1 and 111-2. The first protrusion part 130-1 may be disposed on the upper side of the first bank 111-1 between the red subpixel SPr and the green subpixel SPg. The second protrusion part 130-2 may be disposed on the upper side of the second bank 111-2 between the green subpixel SPg and the blue subpixel SPb.

The left side portion and the right side portion of the protrusion parts 130-1 and 130-2 may have shapes that are symmetrical with respect to the center normal of the protrusion part 130-1 and 130-2, but are not limited thereto. For example, the left side portion and the right side portion of the protrusion part 130-1 and 130-2 may each have an undercut structure. In this instance, the undercut structure on the left side portion and the undercut structure on the right side portion may have shapes that are symmetrical with respect to the center normal of the protrusion part 130-1 and 130-2.

The protrusion part 130-1 and 130-2 may have a connecting structure 105A comprising an auxiliary electrode AC electrically connected to the cathode electrode 123r, 123g and 123b.

The protrusion part 130-1 and 130-2 may comprise a first layer 131 and a second layer 132 on the first layer 131.

The side portion of the first layer 131 may be recessed into the inside of the protrusion part from the side portion of the second layer 132. Accordingly, an undercut structure may be formed on the side portion of the protrusion part by the first layer 131 and the second layer 132. The undercut structure may have a cave shape. For example, the undercut structure may have a U-cave shape. Accordingly, the undercut structure may be called a cave, a U-cave, a cave portion, etc. In order to form an undercut structure, the first layer 131 and the second layer 132 may have different etching selectivity. For example, the first layer 131 may comprise a material having a high etching rate, and the second layer 132 may comprise a material having a low etching rate. Accordingly, when the first layer 131 and the second layer 132 are etched after a photosensitive pattern is formed on the second layer 132, the side portion of the first layer 131 may be etched faster than the side portion of the second layer 132, so that an undercut structure may be formed on the side portion of the protrusion part 130-1 and 130-2.

The first layer 131 and/or the second layer 132 may comprise a metal having excellent electrical conductivity or a conductive oxide material. As the metal, titanium (Ti), molybdenum (Mo), molybdenum-titanium (MoTi), aluminum (Al), copper (Cu), an alloy thereof, etc. may be used. ITO, IZO, etc. can be used as the conductive oxide material.

Meanwhile, by adjusting the target-source distance of the evaporation source (or the evaporation source device), the deposition material can be deposited on the substrate 110 at different deposition angles. The target-source distance can be the distance between the evaporation source and the substrate 110. The deposition angle can be the angle of the virtual line between the evaporation source and the lower edge 132a of the second layer 132 with respect to the normal direction. For example, the larger the target-source distance, the smaller the deposition angle can be. The smaller the deposition angle, the closer the layer formed by the deposition material can be deposited to the adjacent subpixel. The larger the deposition angle, the closer the corresponding layer can be deposited to the protrusion part 130-1 and 130-2.

As illustrated in FIG. 4A, FIG. 4B, and FIG. 4C, since the deposition materials are deposited at different deposition angles, one end of the organic light-emitting layer 122r, 122g, and 122b and one end of the first conductive layer 123-1 of the cathode electrode 123r, 123g, and 123b can be positioned differently from each other.

The cathode electrode 123r, 123g, and 123b can comprise a plurality of conductive layers 123-1 and 123-2. For example, the cathode electrode 123r, 123g, and 123b can comprise the first conductive layer 123-1 and the second conductive layer 123-2 on the first conductive layer 123-1, but three or more conductive layers may be included.

One end of the organic light-emitting layer 122r, 122g and 122b and one end of the first conductive layer 123-1 may be positioned on the upper side of the bank 111-1 and 111-2. For example, one end of the organic light-emitting layer 122r, 122g and 122b may be positioned closer to the first layer 131 than one end of the first conductive layer 123-1.

The second conductive layer 123-2 may be disposed on the entire region of the substrate 110. The second conductive layer 123-2 may be deposited by using a sputtering process. That is, the second conductive layer 123-2 may be disposed on the upper side of the first conductive layer 123-1 of each of the subpixels SPr, SPg, and SPb, the upper side of the bank 111-1 and 111-2, and the side portion and upper side of the protrusion parts 130-1 and 130-2. The second conductive layer 123-2 may be in contact with the side portion of the first layer 131 and/or the lower side of the second layer 132.

For example, the first conductive layer 123-1 may comprise a metal having excellent electrical conductivity, and the second conductive layer 123-2 may comprise a conductive oxide material. For example, the first conductive layer 123-1 may comprise a Mg:Ag alloy, and the second conductive layer 123-2 may comprise ITO, IZO, etc.

The Mg:Ag alloy can be formed as the first conductive layer 123-1 by deposition using an evaporation source. However, since the step coverage characteristics of Mg:Ag are not good, it is difficult for the deposition material comprising the Mg:Ag alloy to be deposited deep inside the undercut structure of the connection structure 105A. In addition, when the uniformity of the film thickness of the first conductive layer 123-1 comprising the Mg:Ag alloy is insufficient or the process margin is insufficient, the first conductive layer 123-1 may not be electrically connected to the auxiliary electrode AC included in the connection structure 105A, resulting in poor electrical connection.

To solve this problem, a conductive oxide material such as ITO having excellent step coverage characteristics may be deposited on the substrate 110 using a sputtering process, so that it can be deposited deep inside the undercut structure of the connection structure 105A. Accordingly, the second conductive layer 123-2 may be stably deposited on the side portion of the first layer 131, which is the auxiliary electrode AC, so that electrical connection failure between the auxiliary electrode AC and the cathode electrode 123r, 123g, and 123b comprising the first conductive layer 123-1 and the second conductive layer 123-2 can be prevented. In addition, since the uniformity of the film thickness of the conductive layer is secured, the stability of the production quality can be improved.

When the second conductive layer 123-2 is formed on the first conductive layer 123-1, there is no need to adjust or manage the deposition angle to deposit the first conductive layer 123-1 using an evaporation source. In addition, even if the organic light-emitting layer 122r, 122g and 122b by using an evaporation source as well as the first conductive layer 123-1 are freely deposited regardless of the deposition angle, the organic light-emitting layers 122r, 122g and 122b can be deposited on the corresponding subpixels SPr, SPg and SPb, and the cathode electrodes 123r, 123g and 123b can be stably connected to the auxiliary electrodes AC of the protrusion parts 130-1 and 130-2 through the second conductive layer 123-2. Therefore, when configured by a combination of the above-described connection structure 105A and the open structure 105B, productivity and material utilization efficiency can be improved through more free deposition processes.

In addition, when the organic light-emitting display device is implemented in a top emission manner, the luminescence efficiency can be improved by utilizing constructive interference between the anode electrode 121r, 121g and 121b and the cathode electrode 123r, 123g and 123b by using the cathode electrode 123r, 123g and 123b which comprises a first conductive layer 123-1 comprising an Ag:Mg alloy and anode electrodes 121r, 121g and 121b comprising a transflective material.

Meanwhile, the protrusion part 130-1 and 130-2 can comprise a fourth layer 134 on the second layer 132. The fourth layer 134 may be omitted. The fourth layer 134 can comprise an inorganic material such as $SiO_2$, SiNx, or SiONx. The fourth layer 134 may comprise a conductive oxide material such as ITO. The fourth layer 134 may act as a stopper for the second layer 132. As described above, in order to form a side-by-side structure, the red subpixel SPr, the green subpixel SPg, and the blue subpixel SPb may be etched twice, respectively. At this time, when these two etchings are performed, the area or thickness of the second layer 132 may change. In this instance, there is a problem in which the deposition angle determined by the edge 132a of the lower side of the second layer 132 is different, and the deposition area in each subpixel SPR, SPG and SPB is different, resulting in a decrease in image quality.

In order to solve the above-mentioned problem, when a fourth layer 134 that acts as a stopper is formed on the second layer 132, even if etching is performed twice, the etching of the second layer 132 may be suppressed or prevented by the fourth layer 134, so that the deposition angle determined by the edge 132a on the lower side of the second layer 132 can be fixed. Accordingly, the deposition area in each of the subpixels SPr, SPg, and SPb may be secured as a target area, so that the image quality can be improved.

Although not illustrated, the third layer may be disposed below the first layer 131, but is not limited thereto. The third layer may comprise a material having a low etching rate. The third layer may comprise a metal or a conductive oxide material having excellent electrical conductivity. The third layer may comprise an inorganic material having a low etching rate.

When the third layer comprises a metal or a conductive oxide material, the third layer may be an auxiliary electrode AC.

The etching rate of the third layer may be the same as or slower than the etching rate of the second layer 132. When the second layer 132 and the third layer are etched simultaneously, since the etching rate of the third layer is the same as or slower than the etching rate of the second layer 132, the side portion of the third layer may be positioned on the same vertical line as the side portion of the second layer 132 or may be disposed to extend further in the direction of the adjacent subpixel from the side portion of the second layer 132.

Meanwhile, the organic light-emitting display device according to the embodiment may comprise an encapsulation layer 135. The encapsulation layer 135 may be a blocking layer that prevents moisture, etc. from penetrating into the organic light-emitting element 120r, 120g, and 120b.

Meanwhile, the organic light-emitting display device according to the embodiment may comprise a plurality of color filter layers 140r, 140g, and 140b and a plurality of encapsulation layers 141r, 141g, and 141b.

The plurality of color filter layers 140r, 140g, and 140b may comprise a resin material. The plurality of encapsulation layers 141r, 141g, and 141b may each comprise a plurality of layers. Some layers of the plurality of layers may comprise an inorganic material and other layers may comprise an organic material.

The red color filter layer 140r may be disposed in the red subpixel SPr. The red color filter layer 140r may be disposed on the red organic light-emitting element 120r in the red subpixel SPr, so that only red light corresponding to the target red wavelength band set for the red color filter layer 140r among the wavelength band of red light emitted from the red organic light-emitting element 120r may be emitted.

The green color filter layer 140g may be disposed on the green subpixel SPg. The green color filter layer 140g may be disposed on the green organic light-emitting element 120g in the green subpixel SPg, so that only green light corresponding to the target green wavelength band set for the green color filter layer 140g among the wavelength band of green light emitted from the green organic light-emitting element 120g may be emitted.

The blue color filter layer 140b may be disposed on the blue subpixel SPb. The blue color filter layer 140b may be disposed on the blue organic light-emitting element 120b in the blue subpixel SPb, so that only blue light corresponding to the target blue wavelength band set for the blue color filter layer among the wavelength band of blue light emitted from the blue organic light-emitting element 120b may be emitted.

The plurality of color filter layers 140r, 140g, and 140b can each have a color filter function that allows only color light of the preset wavelength band to be emitted.

As described above, the plurality of color filter layers 140r, 140g, and 140b can further enhance the color purity of each color compared to when there is no color filter layer, and in particular, can play a role in enhancing the change in color purity according to the viewing angle in an organic light-emitting display device having a top emission structure. Currently, a polarizing plate may be attached to remove light reflected by the reflective material of the anode electrode 121r, 121g, and 121b when external light is incident, but the most important role of a plurality of color filter layers 140r, 140g, and 140b is that the plurality of color filter layers 140r, 140g, and 140b can absorb external light to improve the contrast ratio and further contribute to cost reduction by removing the polarizing plate.

Meanwhile, the plurality of color filter layers 140r, 140g, and 140b can have the function of a photosensitive pattern for forming a pattern of the encapsulation layer 135, the cathode electrode 123r, 123g, and 123b, and the organic light-emitting layer 122r, 122g, and 122b, respectively.

As illustrated in FIG. 4A, the encapsulation layer 135, the cathode electrode 123r, and the red organic light-emitting layer 122r may be etched using the red color filter layer 140r, so that only the red subpixel SPr may be formed. In this instance, one end of the encapsulation layer 135, one end of the cathode electrode 123r, and one end of the red organic light-emitting layer 122r on the first protrusion part 130-1 may be positioned on the same vertical line or diagonal line.

As illustrated in FIG. 4B, the encapsulation layer 135, the cathode electrode 123g, and the green organic light-emitting layer 122g may be etched using the green color filter layer 140g, so that only the green subpixel SPg may be formed. In this instance, one end of the encapsulation layer 135, one end of the cathode electrode 123g, and one end of the green organic light-emitting layer 122g on the first protrusion part 130-1 may be positioned on the same vertical line or diagonal line.

As illustrated in FIG. 4C, the encapsulation layer 135, the cathode electrode 123b, and the blue organic light-emitting layer 122b may be etched using the blue color filter layer 140b, so that only the blue subpixel SPb may be formed. In this instance, one end of the encapsulation layer 135, one end of the cathode electrode 123b, and one end of the blue organic light-emitting layer 122b on the first protrusion part 130-1 may be positioned on the same vertical line or diagonal line.

As an example, the blue organic light-emitting element 120b, the green organic light-emitting element 120g, and the red organic light-emitting element 120r may be formed in that order, but are not limited thereto.

Meanwhile, the encapsulation layer 141r, 141g, and 141b may comprise a plurality of layers comprising organic materials or inorganic materials.

The encapsulation layers 141r, 141g, and 141b may protect the plurality of color filter layers 140r, 140g, and 140b made of resin materials from being etched. For example, when a blue encapsulation layer 141b is formed on a blue color filter layer 140b used for patterning a blue organic light-emitting element 120b, the blue encapsulation layer 141b can prevent the etching of the blue color filter layer 140b while the green organic light-emitting element 120g is etched. Similarly, when a green encapsulation layer 141g is formed on a green color filter layer 140g used for patterning a green organic light-emitting element 120g, the green encapsulation layer 141g can prevent the etching of the green color filter layer 140g while the red organic light-emitting element 120r is etched. Therefore, the red encapsulation layer 141r, the green encapsulation layer 141g, and the blue encapsulation layer 141b can serve as stoppers for preventing etching.

Meanwhile, the plurality of color filter layers 140r, 140g and 140b may each comprise a light scattering agent or a light diffusing agent. Light may be scattered or diffused by the light scattering agent or the light diffusing agent, thereby improving the luminescence efficiency.

Meanwhile, the red encapsulation layer 141r, the green encapsulation layer 141g and the blue encapsulation layer 141b may each comprise a plurality of layers comprising an inorganic material and an organic material.

The red encapsulation layer 141r may be disposed on the red color filter layer 140r, the green encapsulation layer 141g may be disposed on the green color filter layer 140g, and the blue encapsulation layer 141b may be disposed on the blue color filter layer 140b.

The red encapsulation layer 141r, the green encapsulation layer 141g, and the blue encapsulation layer 141b may each comprise at least one or more layer. For example, the red encapsulation layer 141r, the green encapsulation layer 141g, and the blue encapsulation layer 141b may each comprise a first inorganic layer, an organic layer on the first inorganic layer, a second inorganic layer on the organic layer, etc., but are not limited thereto. The first inorganic layer and the second inorganic layer may each comprise an inorganic material such as SiNx, and the organic layer may comprise a resin material, but are not limited thereto.

According to an embodiment, a plurality of subpixels SPr, SPg, and SPb may be sequentially formed to manufacture an organic light-emitting display device having a side-by-side structure. For example, a blue organic light-emitting element 120b, a blue color filter layer 140b, and a blue encapsulation layer 141b may be formed and patterned on the entire region of the substrate 110 using a photolithography process, so that a blue subpixel SPb may be formed. Thereafter, a green organic light-emitting element 120g, a green color filter layer 140g, and a green encapsulation layer 141g may be formed and patterned on the entire region of the substrate 110 using a photolithography process, so that a green subpixel SPg may be formed. Thereafter, a red organic light-emitting element 120r, a red color filter layer 140r, and a red encapsulation layer 141r may be formed and patterned using a photolithography process, so that a red subpixel SPr may be formed.

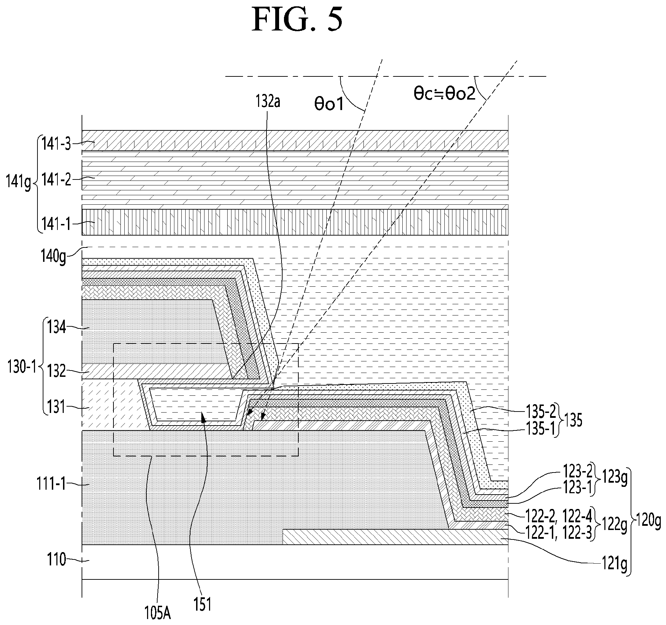

FIG. 5 is a cross-sectional view illustrating an organic light-emitting display device according to the first embodiment. FIG. 5 illustrates the green organic light-emitting element 120g in FIGS. 4A to 4C, but the red organic light-emitting element 120r and the blue organic light-emitting element 120b may also have the same structure or shape as the green organic light-emitting element 120g illustrated in FIG. 5. FIG. 5 is an enlarged view of the asymmetric open-connection structure 105 illustrated in FIG. 4A, and therefore, any description overlapping with the description related to FIG. 4A may be omitted.

Referring to FIGS. 4A, 4B, and 5, the organic light-emitting display device according to the first embodiment may comprise a substrate 110, a first bank 111-1, a first protrusion part 130-1, a green organic light-emitting element 120g, a first encapsulation layer 135, a green color filter layer 140g, a green encapsulation layer 141g, etc. The green encapsulation layer 141g may be referred to as a second encapsulation layer.

The substrate 110 may comprise a material having excellent insulating performance. For example, the substrate 110 may comprise a plastic material, a resin material, glass, etc. The substrate 110 may comprise a rigid material or a flexible material.

The first bank 111-1 may be disposed on the substrate 110 between the red subpixel SPr and the green subpixel SPg. The first protrusion part 130-1 may be disposed on the upper side of the first bank 111-1.

The first protrusion part 130-1 may comprise a connection structure 105A. The connection structure 105A may be formed on each of the left side portion and the right side portion of the first protrusion part 130-1. In this instance, the undercut structure on the left side portion and the undercut structure 151 on the right side portion may be included in the connection structure 105A. For example, the undercut structure on the left side portion may be included in the first connection structure, and the undercut structure 151 on the right side portion may be included in the second connection structure 105A.

The first protrusion part 130-1 may comprise a first layer 131, a second layer 132, a fourth layer 134, etc. The second layer 132 may be disposed on the first layer 131, and the fourth layer 134 may be comprised on the second layer 132. Although not illustrated, a third layer may be disposed below the first layer 131.

The connection structure 105A may comprise an auxiliary electrode AC. The auxiliary electrode AC may be electrically connected to the first power line PL1 via the contact pad 103, as illustrated in FIGS. 1 and 2 .

The auxiliary electrode AC included in the connection structure 105A may be electrically connected to the adjacent subpixels SPr and SPg. For example, the auxiliary electrode AC may be electrically connected to the cathode electrode 123r of the red organic light-emitting element 120r and the cathode electrode 123g of the green organic light-emitting element 120g. That is, the cathode electrode 123r of the red organic light-emitting element 120r may be electrically connected to one side of the auxiliary electrode and may be electrically connected to the cathode electrode 123g of the green organic light-emitting element 120g.

At least one of the first layer 131 or the second layer 132 may comprise a metal or a conductive oxide material having excellent electrical conductivity. In this instance, at least one of the first layer 131 or the second layer 132 may be the auxiliary electrode AC. Therefore, at least one of the first layer 131 or the second layer 132 may be electrically connected to the cathode electrode 123r of the red organic light-emitting element 120r and the cathode electrode 123g of the green organic light-emitting element 120g.

The connection structure 105A may have an undercut structure 151 formed by the first layer 131 and the second layer 132. To this end, the first layer 131 may be formed of a material having a high etching rate, and the second layer 132 may be formed of a material having a low etching rate. Therefore, when the first layer 131 and the second layer 132 are etched, the side portion of the first layer 131 may be etched faster than the side portion of the second layer 132, thereby forming the undercut structure 151. Meanwhile, the etching rate of the third layer may be lower than the etching rate of the first layer 131. The etching rate of the third layer may be the same as or less than the etching rate of the second layer 132. Therefore, when the first layer 131 and the third layer are etched, the sidewall of the third layer may be etched the same as or more slowly than the sidewall of the first layer 131, so that the sidewall of the third layer may be positioned on the same vertical line or diagonal line as the sidewall of the first layer 131 or may extend further in the direction of the green subpixel SPg from the sidewall of the first layer 131.

The green organic light-emitting element 120g may comprise an anode electrode 121g, a green organic light-emitting layer 122g, and a cathode electrode 123g.

As illustrated in FIG. 5, the cathode electrode 123g may comprise a first conductive layer 123-1 and a second conductive layer 123-2 on the first conductive layer 123-1. For example, the first conductive layer 123-1 may comprise a metal having excellent electrical conductivity, and the second conductive layer 123-2 may comprise a conductive oxide material. For example, the first conductive layer 123-1 may comprise a Mg:Ag alloy, and the second conductive layer 123-2 may comprise ITO, IZO, etc.

In the green organic light-emitting layer 122g deposited in the deposition process, high-resistance deposition materials HTL, EML, and ETL may be deposited at a deposition angle $\theta o2$, and the first conductive layer 123-1 of the cathode electrode 123g may be deposited at a deposition angle $\theta c$. The deposition angle $\theta o2$ and the deposition angle $\theta c$ may be similar. The low-resistance deposition materials HIL and CGL may be deposited at a deposition angle $\theta o1$. The deposition angle $\theta o1$ may be 10° or more greater than the deposition angle $\theta o2$ or the deposition angle $\theta c$.

When a conductive oxide material such as ITO having excellent step coverage characteristics is deposited on the substrate 110 using a sputtering process, the conductive oxide material can be deposited deep inside the undercut structure 151 of the connection structure 105A. In addition, the film quality of the layer formed by the conductive oxide material, i.e., the second conductive layer 123-2, is excellent. Accordingly, not only is the second conductive layer 123-2 formed with excellent film quality, but it is also formed deep inside the undercut structure 151 of the connection structure 105A, so that electrical connection failure between the cathode electrode 123g comprising the first conductive layer 123-1 and the second conductive layer 123-2 and the auxiliary electrode AC can be prevented.

In conclusion, since a deposition material comprising ITO having excellent step coverage characteristics is deposited on the substrate 110 through a sputtering process, the deposition material can be deposited not only over the entire region of the substrate 110 but also deep inside the undercut structure 151 of the connection structure 105A. Accordingly, the second conductive layer 123-2 may be electrically connected to the auxiliary electrode AC, i.e., the first layer 131 and/or the second layer 132, so that electrical connection failure between the first conductive layer 123-1 and the auxiliary electrode AC can be prevented.

The second conductive layer 123-2 can be disposed on the cathode electrode 123g of the green organic light-emitting element 120g. The second conductive layer 123-2 can be disposed on the side portion of one end of the green organic light-emitting layer 122g. The second conductive layer 123-2 may be disposed on the upper side of the banks 111-1 and 111-2 between the first protrusion part 130-1 and the green organic light-emitting layer 122g. The second conductive layer 123-2 may be disposed on the side portion of the first layer 131. The second conductive layer 123-2 may be disposed on the lower side, side portion, and/or upper side of the second layer 132.

Meanwhile, not only the first conductive layer 123-1, but also high-resistance organic deposition materials of the green organic light-emitting element 120g, such as the hole transport layer HTL, the green organic light-emitting layer EML, the electron transport layer ETL, etc., may be deposited at the deposition angle $\theta o2$. In an embodiment, the first conductive layer 123-1 may be deposited at the same deposition angle $\theta o2$ together with the hole transport layer HTL, the green organic light-emitting layer EML, the electron transport layer ETL, etc.

Low-resistance organic deposition materials of the green organic light-emitting element 120g, such as hole injection layer HIL, charge generation layers n-CGL and p-CGL, etc., may be deposited at a deposition angle $\theta o1$ smaller than the deposition angle $\theta o2$. Accordingly, high-resistance organic deposition materials can surround low-resistance organic deposition materials, so that low-resistance organic deposition materials may not be exposed.

Specifically, since the deposition angle $\theta o2$ of the high-resistance deposition materials HTL, EML, and ETL is 10° or more greater than the deposition angle θo1 of the low-resistance deposition materials HIL and CGL, the first organic light-emitting stack 122-2 can be formed on the upper side and the side portion of the hole injection layer 122-1, and the second organic light-emitting stack 122-4 can be formed on the upper side as well as the side portion of the charge generation layer 122-3. In addition, since the deposition angle θc of the first conductive layer 123-1 and the deposition angle θo2 of the high-resistance deposition materials HTL, EML, and ETL are equal, the first conductive layer 123-1 can be formed on the upper side of the second organic light-emitting stack 122-4.

Meanwhile, the second conductive layer 123-2 may be formed on the side portion of the first organic light-emitting stack 122-2 and the upper side and the side portion of the second organic light-emitting stack 122-4. In this instance, the second conductive layer 123-2 and the hole injection layer 122-1 may be spaced apart by an amount corresponding to the thickness of the first organic light-emitting stack 122-2 or the sum of the thicknesses of the first organic light-emitting stack 122-2 and the thicknesses of the second organic light-emitting stack 122-4. In addition, the second conductive layer 123-2 and the charge generation layer 122-3 may be spaced apart by an amount corresponding to the thickness of the first organic light-emitting stack 122-2 or the sum of the thicknesses of the first organic light-emitting stack 122-2 and the thicknesses of the second organic light-emitting stack 122-4. Accordingly, since the hole injection layer 122-1 and/or the charge generation layer 122-3 are not electrically connected to the second conductive layer 123-2, poor electrical connection can be prevented.

Therefore, since the low-resistance deposition materials HIL and CGL and the high-resistance deposition materials HTL, EML, and ETL may be deposited at different deposition angles θo1 and θo2, so that the hole injection layer 122-1 and the charge generation layer 122-3 are electrically disconnected from the second conductive layer 123-2 of the cathode electrode 123g, the formation of an open structure (105B in FIGS. 4A to 4C) is not necessary, and thus the process can be simplified and the process cost can be reduced.

However, although the process cost is increased by adding the open structure 105B, double blocking is possible, so that anode-cathode leakage current due to insufficient process margin in an emergency can be completely prevented. In particular, it may be desirable to adjust the deposition angle as well as the open structure 105B in order of thickness, i.e., the blue organic light-emitting diode 120b and the green organic light-emitting diode 120g.

The encapsulation layer 135 may be disposed on the green organic light-emitting element 120g and the first protrusion part 130-1. The encapsulation layer 135 may play a blocking role to prevent moisture, etc. from penetrating into the green organic light-emitting element 120g. The encapsulation layer 135 may comprise a plurality of insulating layers 135-1 and 135-2, but is not limited thereto. For example, the encapsulation layer 135 may comprise the first-first insulating layer 135-1 and the first-second insulating layer 135-2 on the first-first insulating layer 135-1. For example, the first-first insulating layer 135-1 may be an inorganic layer comprising $SiO_2$, etc., and the first-second insulating layer 135-2 may be an inorganic layer comprising SiNx, etc., but is not limited thereto.

As illustrated in FIG. 5, the first-first insulating layer 135-1 may also be disposed inside the undercut structure 151 of the connection structure 105A. That is, the first-first insulating layer 135-1 may be disposed on the side portion of the first layer 131, the lower side of the second layer 132, etc. The first-second insulating layer 135-2 may not be disposed inside the undercut structure 151 of the connection structure 105A, but is not limited thereto.

The green color filter layer 140g may be disposed on the green organic light-emitting element 120g, and the green encapsulation layer 141g may be disposed on the green color filter layer 140g.

The green encapsulation layer 141g may comprise, but is not limited to, a second-first insulating layer 141-1, a second-second insulating layer 141-2, a second-third insulating layer 141-3, etc. The second-first insulating layer 141-1 and the second-third insulating layer 141-3 may each comprise an inorganic material such as SiNx, and the second-second insulating layer 141-2 may comprise a resin material, but is not limited to thereto.

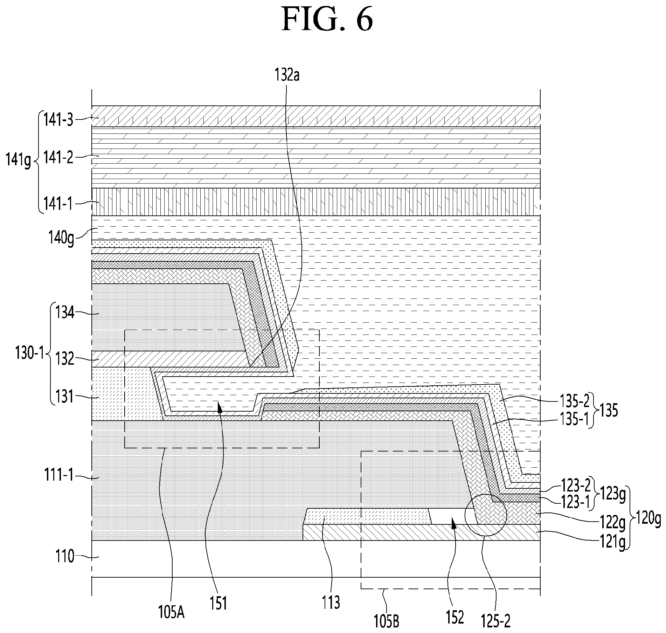

FIG. 6 is a cross-sectional view illustrating an organic light-emitting display device according to a second embodiment. Although FIG. 6 illustrates the green organic light-emitting element 120g in FIGS. 4A to 4C, the red organic light-emitting element 120r and the blue organic light-emitting element 120b may also have the same structure or shape as the green organic light-emitting element 120g illustrated in FIG. 6. FIG. 6 is an enlarged view of the asymmetric open-connection structure 105 illustrated in FIG. 4A, and therefore, any description overlapping with the description related to FIG. 4A may be omitted.

The second embodiment may be the same as the first embodiment (FIG. 5) except for the open structure 105B. In the second embodiment, components having the same shape, structure, and/or function as those in the first embodiment (FIG. 5) are given the same drawing reference numerals, and detailed descriptions are omitted.

Referring to FIGS. 4A, 4B, and 6, the organic light-emitting display device according to the second embodiment may comprise a substrate 110, a first bank 111-1, a first protrusion part 130-1, a green organic light-emitting element 120g, a first encapsulation layer 135, a green color filter layer 140g, a green encapsulation layer 141g, etc. The green encapsulation layer 141g may be referred to as a second encapsulation layer.

The organic light-emitting display device according to the second embodiment may comprise an open structure 105B. The open structure 105B may be provided in an edge region of the first bank 111-1. The open structure 105B may be configured as an asymmetric open-connection structure 105 together with the connection structure 105A.

The open structure 105B may comprise a blocking layer 113. The blocking layer 113 may comprise an inorganic material or a metal. For example, the blocking layer 113 may comprise an inorganic material such as $SiO_2$. For example, the blocking layer 113 may comprise a metal such as aluminum (Al) or molybdenum (Mo).

The open structure 105B may have an undercut structure 152. By etching the side portion of the blocking layer 113, the undercut structure 152 may be formed inwardly from the side portion of the first bank 111-1. The undercut structure 151 of the connection structure 105A may be called a first undercut structure, and the undercut structure 152 of the open structure 105B may be called a second undercut structure, or vice versa.

A separation structure 125-2 may be formed in which some layers of the green organic light-emitting element 120g are isolated by the undercut structure 152 of the open structure 105B. The separation structure 125-2 formed in the green organic light-emitting element 120g may be formed corresponding to the open structure 105B, specifically, the undercut structure 152.

As an example, the green organic light-emitting element 120g may comprise a hole injection layer. The cathode electrode 123g may be in contact with an end of the hole injection layer, and the anode electrode 121g may be disposed below the hole injection layer. When the hole injection layer comprises a low-resistance organic light-emitting material, a leakage current may flow between the anode electrode 121g and the cathode electrode 123g through the hole injection layer. Therefore, an electrical short between the anode electrode 121g and the cathode electrode 123g may occur, so that the corresponding subpixels SPr, SPg, and SPb do not emit light or the luminance may be significantly reduced compared to the target luminance, resulting in poor image quality. According to an embodiment, a separation structure 125-2 corresponding to the open structure 105B may be formed in the hole injection layer. A portion corresponding to the separation structure 125-2 in the hole injection layer may be isolated. By isolating the hole injection layer, the electrical short between the anode electrode 121g and the cathode electrode 123g may be blocked, thereby preventing poor image quality.

As another example, the green organic light-emitting element 120g may have a two-stack structure, comprising a hole injection layer, a first organic light-emitting stack, a charge generation layer, and a second organic light-emitting stack. In this instance, the cathode electrode 123g may be in contact with one end of the charge generation layer, and one end of the charge generation layer may be in contact with one end of the hole injection layer. Accordingly, since the hole injection layer and the charge generation layer are made of a low-resistance organic light-emitting material, an electrical short may occur between the anode electrode 121g and the cathode electrode 123g through the hole injection layer and the charge generation layer, which may cause poor image quality. According to an embodiment, a separation structure 125-2 corresponding to the blocking structure 105B can be formed in the hole injection layer, the first organic light-emitting stack, and the charge generation layer. Parts corresponding to the separation structure 125-2 in the hole injection layer, the first organic light-emitting stack, and the charge generation layer may be isolated. Since the hole injection layer, the first organic light-emitting stack, and the charge generation layer are each isolated, the electrical short between the anode electrode 121g and the cathode electrode 123g may be blocked, which may prevent poor image quality.

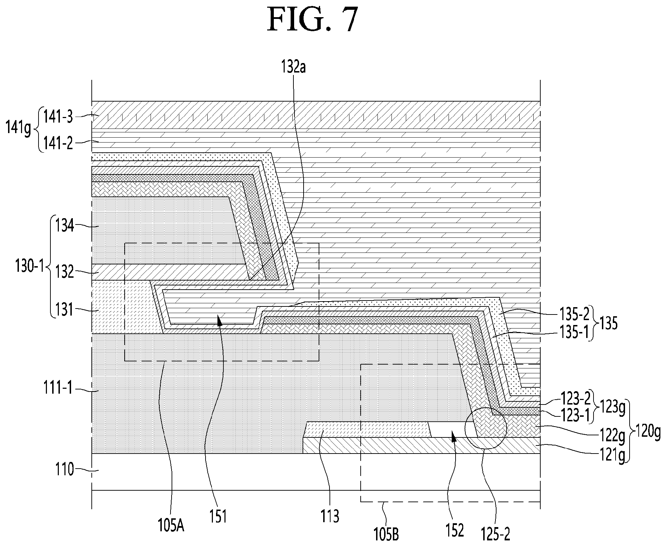

FIG. 7 is a cross-sectional view illustrating an organic light-emitting display device according to a third embodiment. FIG. 7 illustrates the green organic light-emitting element 120g in FIGS. 4A to 4C, but the red organic light-emitting element 120r and the blue organic light-emitting element 120b may also have the same structure or shape as the green organic light-emitting element 120g illustrated in FIG. 7. FIG. 7 is an enlarged view of the asymmetric open-connection structure 105 illustrated in FIG. 4A, so that any description overlapping with the description related to FIG. 4A may be omitted.

The third embodiment is similar to the second embodiment (FIG. 6) except that the green color filter layer (140g of FIG. 6) is omitted. In the third embodiment, components having the same shape, structure, and/or function as those in the second embodiment (FIG. 6) are given the same drawing reference numerals, and detailed descriptions are omitted.

Referring to FIGS. 4A, 4B, and 7, the organic light-emitting display device according to the second embodiment may comprise a substrate 110, a first bank 111-1, a first protrusion part 130-1, a green organic light-emitting element 120g, a first encapsulation layer 135, a green encapsulation layer 141g, etc. The green encapsulation layer 141g may be referred to as a second encapsulation layer.

Unlike the second embodiment (FIG. 6), the green color filter layer (140g of FIG. 6) may be omitted in the third embodiment (FIG. 7).

A green encapsulation layer 141g may be formed on a green organic light-emitting element 120g. The green encapsulation layer 141g may serve to prevent moisture, etc. from penetrating into the green organic light-emitting element 120g. The green encapsulation layer 141g may serve to protect the green organic light-emitting element 120g from external impact, etc. The green encapsulation layer 141g may serve to make the upper surface of the organic light-emitting display device, i.e., the upper surface of the green encapsulation layer 141g, flat. To this end, at least one of the plurality of insulating layers 141-2 and 141-3 included in the green encapsulation layer 141g may comprise an organic layer having a thick thickness.

In the second embodiment (FIG. 6), the green encapsulation layer 141g may comprise a second-first insulating layer 141-1 to a second-third insulating layer 141-3, whereas in the third embodiment (FIG. 7), the green encapsulation layer 141g can comprise the second-second insulating layer 141-2 and the second-third insulating layer 141-3. That is, in the third embodiment (FIG. 7), the second-first insulating layer 141-1 may be omitted.

For example, by forming the thickness of the second-second insulating layer 141-2 thickly using a resin material that is easy to form a thickness, the upper surface of the second-second insulating layer 141-2 may have a flat surface. By forming the second-third insulating layer 141-3 on the second-second insulating layer 141-2, the upper surface of the second-third insulating layer 141-3 may also have a flat surface.

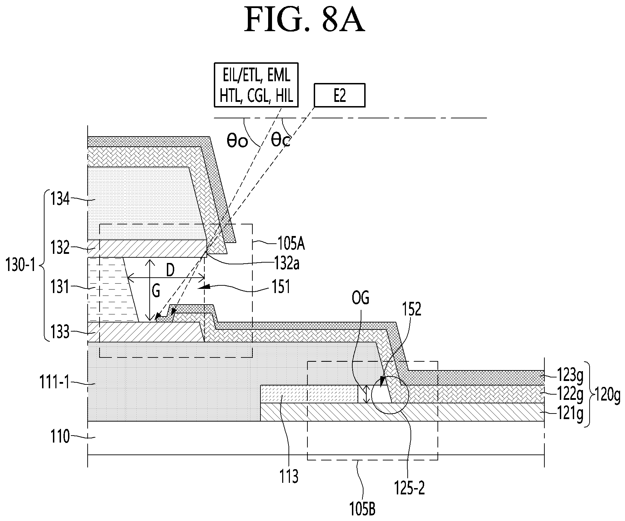

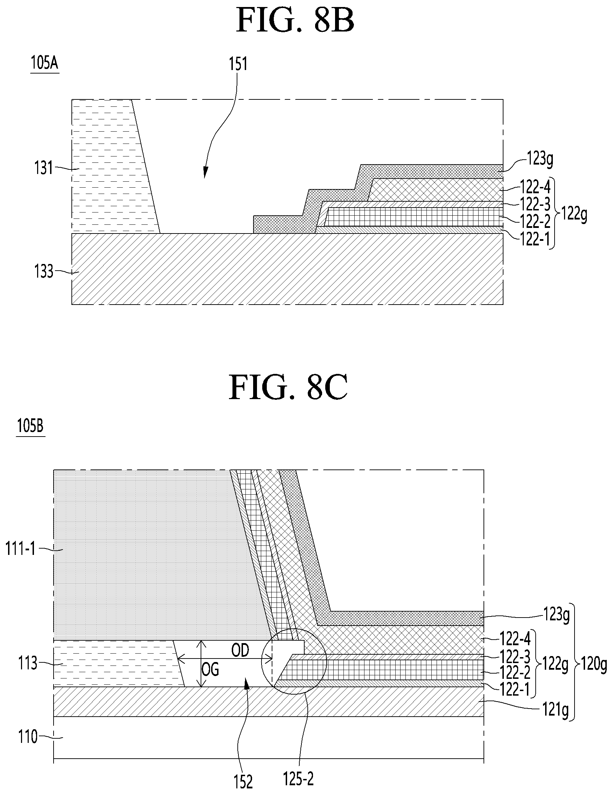

FIG. 8A is a cross-sectional view illustrating an organic light-emitting display device according to a fourth embodiment. FIG. 8B is a cross-sectional view illustrating a connection structure in the asymmetric open-connection structure of FIG. 8A. FIG. 8C is a cross-sectional view illustrating an open structure in the asymmetric open-connection structure of FIG. 8A.

Although FIGS. 8A to 8C illustrate the green organic light-emitting element 120g in FIGS. 4A to 4C, the red organic light-emitting element 120r and the blue organic light-emitting element 120b may also have the same structure or shape as the green organic light-emitting element 120g illustrated in FIG. 8A. FIG. 8A is an enlarged view of the asymmetric open-connection structure 105 illustrated in FIG. 4A, and therefore, any description overlapping with the description related to FIG. 4A may be omitted.

The fourth embodiment is similar to the second embodiment (FIG. 6) and/or the third embodiment (FIG. 7) except for the green organic light-emitting element 120g having a two-stack structure and the third layer 133 of the first protrusion part 130-1. In the fourth embodiment, components having the same shape, structure, and/or function as those in the second embodiment (FIG. 6) and/or the third embodiment (FIG. 7) are given the same drawing reference numerals, and detailed descriptions thereof are omitted.

Referring to FIGS. 4A, 4B, and 8A to 8C, an organic light-emitting display device according to a fourth embodiment may comprise a substrate 110, a first bank 111-1, a first protrusion part 130-1, a green organic light-emitting element 120g, etc.

The first protrusion part 130-1 may have a connection structure 105A. The connection structure 105A may comprise an auxiliary electrode AC electrically connected to a cathode electrode 123g of the green organic light-emitting element 120g. As illustrated in FIGS. 1 and 2, the auxiliary electrode AC may be connected to a first power line PL1 via a contact pad 103. In this instance, a predetermined current can flow to the first power line PL1 via the anode electrode 121g of the green organic light-emitting element 120g, the green organic light-emitting layer 122g, the cathode electrode 123g, and the auxiliary electrode AC. In this instance, green light having a luminance corresponding to the current can be emitted upwardly, i.e., forwardly, from the green organic light-emitting layer 122g. In contrast, in the bottom emission manner, green light emitted from the green organic light-emitting layer 122g can proceed downwardly, i.e., backwardly.

The first protrusion part 130-1 can comprise a first layer 131, a second layer 132, a third layer 133, and a fourth layer 134. The second layer 132 may be disposed on the first layer 131, the third layer 133 may be disposed below the first layer 131, and the fourth layer 134 may be disposed on the second layer 132. Since the first layer 131, the second layer 132, and the fourth layer 134 have already been described above, their detailed descriptions will be omitted.

The third layer 133 may comprise, for example, a metal having excellent electrical conductivity or a conductive oxide material. Accordingly, the third layer 133 may be an auxiliary electrode AC. The cathode electrode 123g may be disposed on the side portion and upper side of the third layer 133, so that the third layer 133 may be electrically connected to the cathode electrode 123g.

The third layer 133 may comprise a material having a low etching rate. For example, the etching rate of the third layer 133 may be lower than the etching rate of the first layer 131. For example, the etching rate of the third layer 133 may be the same as or slower than the etching rate of the second layer 132. When the second layer 132 and the third layer 133 are etched simultaneously, since the etching rate of the third layer 133 is the same as or slower than the etching rate of the second layer 132, the side portion of the third layer 133 may be positioned on the same vertical line as the side portion of the second layer 132 or may be disposed to extend further in the direction of the adjacent subpixel from the side portion of the second layer 132.

An undercut structure 151 may be formed by the first layer 131, the second layer 132, and the third layer 133. That is, an undercut structure 151 may be formed in which the side portion of the first layer 131 is recessed in the inner direction of the first protrusion part 130-1 from the side portion of the second layer 132 and/or the side portion of the third layer 133. In the undercut structure 151 of the connection structure 105A, the depth (or width) into which the side portion of the first layer 131 is recessed may be defined as the opening depth D. In the undercut structure 151 of the connection structure 105A, the width in the vertical direction between the third layer 133 and the second layer 132 may be defined as the opening gap G.

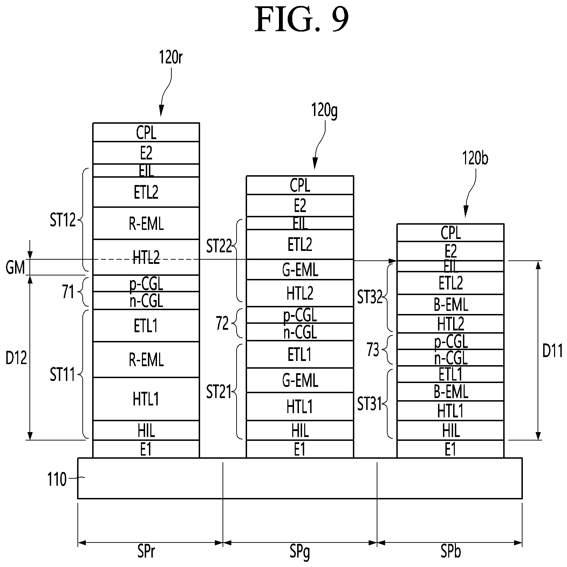

Meanwhile, as illustrated in FIG. 9, not only the green organic light-emitting element 120g, but also the red organic light-emitting element 120r and the blue organic light-emitting element 120b may be disposed on the substrate 110. The red organic light-emitting element 120r may be disposed in the red subpixel SPr, the green organic light-emitting element 120g may be disposed in the green subpixel SPg, and the blue organic light-emitting element 120b may be disposed in the blue subpixel SPb.

The red organic light-emitting element 120r, the green organic light-emitting element 120g, and the blue organic light-emitting element 120b may each have a two-stack structure.

The red organic light-emitting element 120r may comprise an anode electrode E1, a first organic light-emitting stack ST11 on the anode electrode E1, a charge generation layer 71 on the first organic light-emitting stack ST11, a second organic light-emitting stack ST12 on the charge generation layer 71, a cathode electrode E2 on the second organic light-emitting stack ST12, a capping layer CPL on the cathode electrode E2, etc.

The green organic light-emitting element 120g may comprise an anode electrode E1, a first organic light-emitting stack ST21 on the anode electrode E1, a charge generation layer 72 on the first organic light-emitting stack ST21, a second organic light-emitting stack ST22 on the charge generation layer 72, a cathode electrode E2 on the second organic light-emitting stack ST22, a capping layer CPL on the cathode electrode E2, etc.

The blue organic light-emitting element 120b may comprise an anode electrode E1, a first organic light-emitting stack ST31 on the anode electrode E1, a charge generation layer 73 on the first organic light-emitting stack ST31, a second organic light-emitting stack ST32 on the charge generation layer 73, a cathode electrode E2 on the second organic light-emitting stack ST32, a capping layer CPL on the cathode electrode E2, etc.

The charge generation layer 71 to 73 may comprise an n-type charge generation layer n-CGL and a p-type charge generation layer p-CGL on the n-type charge generation layer n-CGL.

In the top emission manner, the light extraction efficiency in the viewing angle direction may be improved through constructive interference. To this end, the thickness of the layers between the anode electrode E1 and the cathode electrode E2 may be designed so that the distance between the anode electrode E1 and the cathode electrode E2 in each of the red subpixel SPr, the green subpixel SPg, and the blue subpixel SPb is m (where m is an integer) times the wavelength of the corresponding light. For example, in an organic light-emitting display device having a side-by-side structure, the thickness may decrease in the order of the red organic light-emitting element 120r, the green organic light-emitting element 120g, and the blue organic light-emitting element 120b. That is, the thickness of the red organic light-emitting element 120r may be the largest, the thickness of the green organic light-emitting element 120g may be the next largest, and the thickness of the blue organic light-emitting element 120b may be the smallest.

The drawing numbers of FIGS. 8B and 9 correspond as illustrated in Table 1 and may be used interchangeably. The drawing numbers illustrated in FIG. 9 may mean the physical layer illustrated in FIG. 8B or may mean the deposition material for forming the corresponding physical layer.

[Table 1]

| FIG. 8A | FIG. 9 |
|---------|--------|
| 121g | E1 |
| 122-1 | HIL |
| 122-2 | ST21 |
| 122-3 | 72 |
| 123-4 | ST22 |
| 123g | E2 |

Referring again to FIGS. 8A and 8B, low-resistance organic light-emitting materials HIL and CGL as well as high-resistance materials HTL, EML, EIL and ETL may be deposited on a substrate 110 at a deposition angle θo to form a first organic light-emitting stack 122-2 comprising a hole injection layer 122-1, a charge generation layer 122-3 and a second organic light-emitting stack 122-4. A metal deposition material E2 may be deposited on the substrate 110 at a deposition angle θc smaller than the deposition angle θo with respect to a horizontal direction to form a cathode electrode 123g. The cathode electrode 123g may be a single layer comprising, for example, Mg:Ag. In this instance, the cathode electrode 123g must be electrically connected directly to the auxiliary electrode AC of the first protrusion part 130-1. To this end, when the metal deposition material E2 is deposited on the substrate 110 at a smaller deposition angle θc, the metal deposition material E2 can also be formed inside the undercut structure 151 of the connection structure 105A. For example, the cathode electrode 123g can be disposed on the upper side of the third layer 133, which is the auxiliary electrode AC, and can be electrically connected with the third layer 133. When the metal deposition material E2 is deposited at a deposition angle θc smaller than the deposition angle θo, the cathode electrode 123g can be disposed on the side portion of the first layer 131, which is the auxiliary electrode AC, and can be electrically connected with the first layer 131. For example, since the deposition angle θc may be set to be 10° or more smaller than the deposition angle θo, so that the cathode electrode 123g may be formed inside the undercut structure 151 of the connection structure 105A, the auxiliary electrode AC of the first protrusion part 130-1 can be electrically connected to the cathode electrode 123g.

In FIG. 8A, the deposition angle θc and the deposition angle θo may be deposition angles with respect to the horizontal direction, but may also be defined as deposition angles with respect to the vertical direction.

Meanwhile, when the first protrusion part 130-1 has a square shape when viewed from above, the cathode electrode 123g can be electrically connected to the auxiliary electrode AC at least two or more edges among the four edges of the first protrusion part 130-1, but is not limited thereto. At this time, since the placement position of the evaporation source for discharging the metal deposition material and the adjustment and management of the deposition angle θc are possible within the range of the conventional production method, it does not affect the uniformity of the film thickness, the homogeneity of the film quality, the productivity, the material utilization efficiency, etc.

As illustrated in FIG. 2, FIG. 8A, and FIG. 8B, the cathode electrode 123g can be in contact with the hole injection layer 122-1 and the charge generation layer 122-3 formed with low-resistance organic light-emitting materials at two or more edges among the four edges of the green subpixel SPg. For example, one end of the charge generation layer 122-3 can be in contact with one end of the hole injection layer 122-1. The cathode electrode 123g can be in contact with one end of the hole injection layer 122-1 and one end of the charge generation layer 122-3. Therefore, the cathode electrode 123g can be electrically connected to the anode electrode 121g through the hole injection layer 122-1, etc. In this instance, the current path between the anode electrode 121g and the cathode electrode 123g is as follows.

-    Anode electrode 121g → Charge generation layer 122-3 → Cathode electrode 123g

-    Anode electrode 121g → Auxiliary electrode AC → Hole injection layer 122-1 → Cathode electrode 123g

-    Anode electrode 121g → (Auxiliary electrode AC or hole injection layer 122-1) → Cathode electrode 123g

This current path can cause loss due to leakage current as well as poor image quality due to electrical short between the anode electrode 121g and the cathode electrode 123g.

As illustrated in FIGS. 8A to 8C, the cathode electrode 123g may be electrically connected to the auxiliary electrode AC by the connection structure 105A, while the electrical short between the anode electrode 121g and the cathode electrode 123g may be blocked by the open structure 105B, so that loss due to leakage current and poor image quality are prevented, resulting in excellent quality stability.

The organic light-emitting display device according to the fourth embodiment may comprise the open structure 105B.

Since the hole injection layer 122-1 or the charge generation layer 122-3 is isolated in response to the open structure 105B, the electrical short between the anode electrode 121g and the cathode electrode 123g can be blocked.

As illustrated in FIG. 8C, since the cathode electrode 123g disposed on the uppermost layer of the green organic light-emitting element 120g must be electrically connected to the auxiliary electrode AC, it must not be isolated by the open structure 105B.

The open structure 105B may have an undercut structure 152 formed by at least one or more blocking layer 113. The undercut structure 152 of the open structure 105B may have a blocking gap OG and a blocking depth OD. The blocking gap OG may correspond to the thickness of the blocking layer 113. The blocking gap OG may be, for example, a distance between the anode electrode 121g and the first bank 111-1, but is not limited thereto. The blocking depth OD may be a depth at which a side portion of the blocking layer 113 is recessed from a side portion of the first bank 111-1 into the inside of the first bank 111-1.

As illustrated in FIG. 9, in the red organic light-emitting element 120r in which the distance between the anode electrode E1 and the cathode electrode E2 is the largest, the hole injection layer HIL, the first organic light-emitting stack ST11, and the charge generation layer 71 can be isolated by the open structure 105B. In the blue organic light-emitting element 120b in which the distance between the anode electrode E1 and the cathode electrode E2 is the smallest, the hole injection layer HIL, the first organic light-emitting stack ST31, the charge generation layer 73, and the second organic light-emitting stack ST32 may be isolated by the open structure 105B, but the cathode electrode E2 should not be isolated by the open structure 105B. Therefore, the margin GM of the blocking gap OG in the red organic light-emitting element 120r, the green organic light-emitting element 120g, and the blue organic light-emitting element 120b can be expressed by Equation 1.

[Equation 1] [238] GM = distance D11 between the anode electrode E1 and the cathode electrode E2
in the blue organic light-emitting element 120b - distance D12 between the cathode electrode E2 and    [Equation 1]
the second organic light-emitting stack in the red organic light-emitting element 120r

The margin GM of the blocking gap OG can be set to a minimum value for the distance between the cathode electrode E2 and the second organic light-emitting stack in the red organic light-emitting element 120r, and a maximum value for the distance between the anode electrode E1 and the cathode electrode E2 in the blue organic light-emitting element 120b. Therefore, the margin GM of the blocking gap OG can be set between the distance between the cathode electrode E2 and the second organic light-emitting stack in the red organic light-emitting element 120r and the distance between the anode electrode E1 and the cathode electrode E2 in the blue organic light-emitting element 120b.

The thickness of the blocking gap OG can be set based on a deposition simulation experiment and an actual deposition experiment based on a method of setting the blocking gap calculated from the thickness of the organic light-emitting element 120r, 120g, and 120b by color.

Considering the margin GM of this blocking gap OG, some layers constituting the green organic light-emitting element 120g, such as the hole injection layer HIL, the first organic light-emitting stack ST21, the charge generation layer 72, etc., may be isolated in response to the open structure 105B, so that the electrical short between the anode electrode E1 and the cathode electrode E2 in the green organic light-emitting element 120g can be blocked, thereby preventing loss due to leakage current and poor image quality.

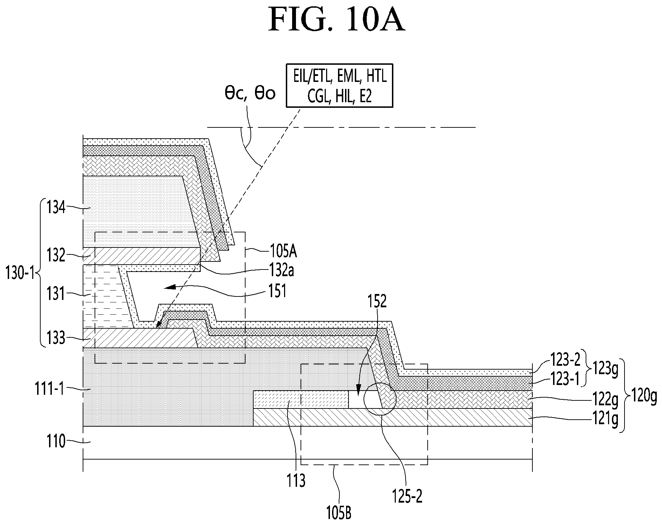

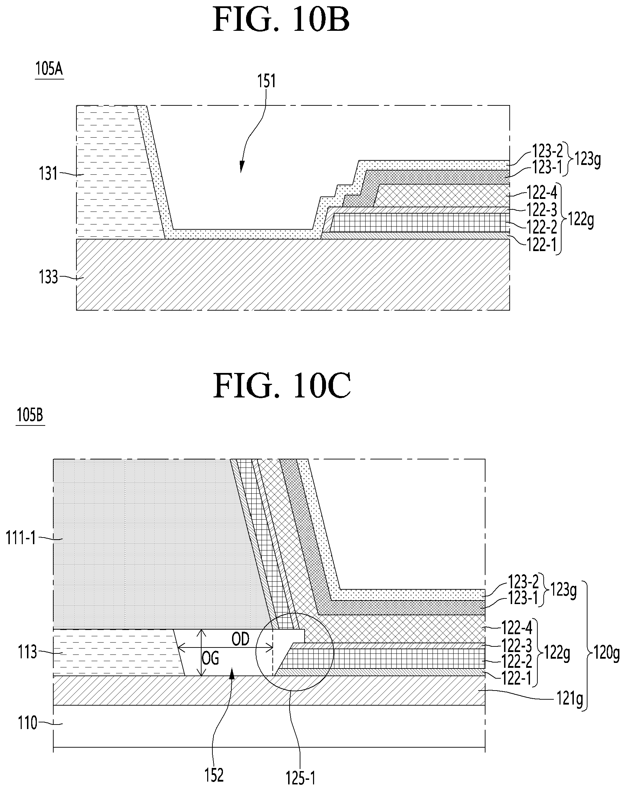

FIG. 10A is a cross-sectional view illustrating an organic light-emitting display device according to a fifth embodiment. FIG. 10B is a cross-sectional view illustrating a connection structure in the asymmetric open-connection structure of FIG. 10A. FIG. 10C is a cross-sectional view illustrating an open structure in the asymmetric open-connection structure of FIG. 10A.

FIGS. 10A to 10C illustrate the green organic light-emitting element 120g in FIGS. 4A to 4C, but the red organic light-emitting element 120r and the blue organic light-emitting element 120b may also have the same structure or shape as the green organic light-emitting element 120g illustrated in FIG. 10A. FIG. 10A is an enlarged view of the asymmetric open-connection structure 105 illustrated in FIG. 4A, so that any description overlapping with the description related to FIG. 4A may be omitted.

The fifth embodiment is identical to the fourth embodiment (FIGS. 8A to 8C) except for the cathode electrode 123g comprising the first conductive layer 123-1 and the second conductive layer 123-2. Components having the same shape, structure, and/or function as those of the fourth embodiment (FIGS. 8A to 8C) are given the same drawing reference numerals and detailed descriptions are omitted.

Referring to FIGS. 4A, 4B, and 10A to 10, an organic light-emitting display device according to the fifth embodiment may comprise a substrate 110, a first bank 111-1, a first protrusion part 130-1, a green organic light-emitting element 120g, etc.

In the fourth embodiment (FIGS. 8A to 8C), the cathode electrode 123g may comprise a single layer comprising Mg:Ag, etc., while in the fifth embodiment (FIGS. 10A to 10C), the cathode electrode 123g may comprise a plurality of conductive layers 123-1 and 123-2. The drawing illustrates a cathode electrode 123g comprising a first conductive layer 123-1 and a second conductive layer 123-2, but the cathode electrode 123g may comprise three or more conductive layers.

For example, the step coverage characteristics of the second conductive layer 123-2 may be superior to the step coverage characteristics of the first conductive layer 123-1. The first conductive layer 123-1 may comprise a material having superior bonding characteristics and work function characteristics with the green organic light-emitting element 120g. For example, the first conductive layer 123-1 may comprise a metal such as Mg:Ag. The second conductive layer 123-2 may comprise a conductive oxide material such as ITO, IZO, etc.

For example, the first conductive layer 123-1 has a step coverage characteristic inferior to that of the second conductive layer 123-2, so that the film quality of the first conductive layer 123-1 may be not good and may be difficult to deposit inside the undercut structure 151 of the connection structure 105A.

According to an embodiment, a metal deposition material such as Mg:Ag forming the first conductive layer 123-1 may be deposited only on the green subpixel SPg at a deposition angle $\theta c$. That is, the metal deposition material may not be deposited inside the undercut structure 151 of the connection structure 105A. In this instance, the second conductive layer 123-2 may be formed on the first conductive layer 123-1 and may be formed deep inside the undercut structure 151 of the connection structure 105A, so that the second conductive layer 123-2 can be electrically connected to the auxiliary electrode AC of the connection structure 105A.

Therefore, since there is no need to design the position of the evaporation source so that the deposition angle $\theta c$ is very small for the metal deposition material to deposit inside the undercut structure of the connection structure 105A, the degree of freedom in the design of the evaporation source can be increased.

Meanwhile, a low-resistance organic deposition material or a high-resistance organic deposition material constituting a green organic light-emitting element (120g in FIG. 9) having a two-stack structure can be deposited on the green subpixel SPg at a deposition angle $\theta o$. A hole injection layer or a charge generation layer can be formed using the low-resistance organic light-emitting material. A hole transport layer, a green organic light-emitting layer 122g, an electron transport layer, an electron injection layer, etc. can be formed using the high-resistance material.

Since the deposition angle $\theta c$ is the same as or similar to the deposition angle $\theta o$, the target-source distance of the evaporation source that discharges the metal deposition material and the target-source distance of the evaporation source that discharges the low-resistance organic deposition material or the high-resistance organic deposition material can be designed to be the same, so that the evaporation sources in each of the plurality of chambers constituting the deposition system can be installed the same or similarly, thereby being easy the design of each chamber.

As described above, a deposition material composed of a material having excellent step coverage characteristics, such as a conductive oxide material such as ITO or IZO, can be deposited on the substrate 110 using a sputtering process. Since the deposition material is dispersed over the entire region of the substrate 110 through the sputtering process, the deposition material can be deposited deep inside the undercut structure 151 of the connection structure 105A as well as the green subpixel SPg. Accordingly, the second conductive layer 123-2 may be formed on the upper side of the green organic light-emitting element 120g as well as on the upper side of the third layer 133 constituting the connection structure 105A, the side portion of the first layer 131, and the lower side, side portion, and/or upper side of the second layer 132.

The first conductive layer 123-1 may contribute to the improvement of electrical/optical characteristics with the green organic light-emitting element 120g, and the second conductive layer 123-2 may strengthen the electrical connectivity between the green organic light-emitting element 120g and the auxiliary electrode AC, thereby improving the electrical/optical characteristics of each of the subpixels SPr, SPg, and SPb, and preventing poor image quality due to poor electrical connection of each of the subpixels SPr, SPg, and SPb.

In addition, in the open structure 105B, the margin of the appropriate blocking gap OG (GM of FIG. 9) for blocking the organic films 122-1, 122-2, and 122-3, which have different thicknesses of elements for each color pixel, with the same blocking gap OG may be insufficient, so that the first conductive layer 123-1 may be opened. The second conductive layer 123-2 may be formed on the upper side of the first conductive layer 123-1 where an open has occurred, and may connect the open of the first conductive layer 123-1 by utilizing the excellent characteristics of the step coverage. Therefore, in the asymmetric open-connection structure 105 of the embodiment, the double layers 123-1 and 123-2 of the cathode electrode 123g may be complementary to each other.

As illustrated in FIG. 10B, since the deposition angle $\theta c$ is equal to or similar to the deposition angle $\theta o$, each of the hole injection layer and charge generation layer made of low-resistance organic light-emitting material, the green organic light-emitting layer 122g made of high-resistance material, and the first conductive layer 123-1 may have one end positioned on a vertical line or a diagonal line. Alternatively, one end of the first conductive layer 123-1 may cover a side portion of one end of the green organic light-emitting layer 122g.

Although the drawing illustrates one end of the first conductive layer 123-1 as being in contact with the third layer 133, which is the auxiliary electrode AC, it may not be in contact with the third layer 133. Even if the first conductive layer 123-1 does not contact the third layer 133, since the second conductive layer 123-2 contacts the first layer 131, the second layer 132, and the third layer 133, which are auxiliary electrodes, an electrical connection failure may not occur.

Meanwhile, as illustrated in FIG. 10C, an open structure 105B may be formed by the blocking layer 113. For example, an undercut structure 152 may be formed in the open structure 105B by the side portion of the blocking layer 113 which is recessed into the inside of the first bank 111-1 from the side portion of the first bank 111-1. In this instance, a separation structure 125-2 may be formed on some layers constituting the green organic light-emitting element (120g in FIG. 9), such as the hole injection layer HIL, the first organic light-emitting stack ST21, and the charge generation layer 72, corresponding to the open structure 105B. In the separation structure 125-2, the hole injection layer HIL, the first organic light-emitting stack ST21, and the charge generation layer 72 may be isolated, so that electrical short between the anode electrode 121g and the cathode electrode 123g in the green organic light-emitting device 120g can be blocked to prevent loss due to leakage current and poor image quality.

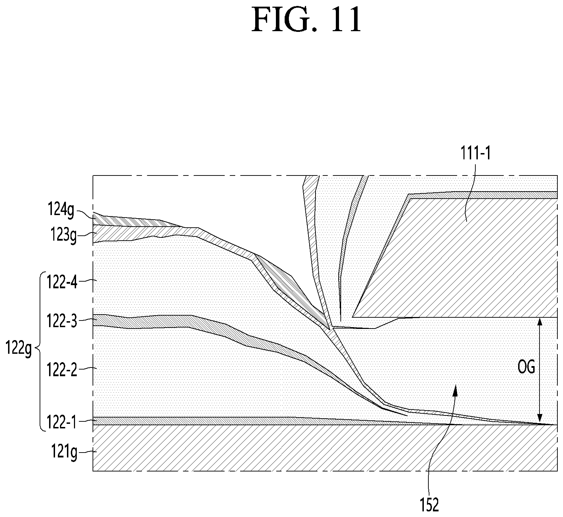

FIG. 11 shows the deposition simulation results of the green organic light-emitting element deposited around the undercut structure of the open structure. During an actual deposition process, the deposition material may be deposited on the deposition surface in a state where the deposition surface is disposed to face the evaporation source positioned at the lower side of the chamber. Therefore, the deposition simulation result illustrated in FIG. 11 may be a state where the substrate 110 on which the actual deposition process is performed is flipped 180 degrees. The deposition simulation result of the green organic light-emitting element illustrated in the drawing may be applied to the deposition simulation result of the red organic light-emitting element, the blue organic light-emitting element, and the green organic light-emitting element in the same or similar manner.

Hereinafter, the mathematical values used in the deposition simulation results are only examples and may change in actual or optimized products.

As illustrated in FIG. 11, the total thickness of the green organic light-emitting element may be 3,336 Å. The blocking gap OG may be the distance between the anode electrode 121 g and the bank 111-1 in the open structure 105B, and may be, for example, 0.18 $\mu$m.

In this instance, the blocking layer and the bank 111-1 may have different etching selectivity from each other. For example, the etch rate of the blocking layer may be greater than the etch rate of the bank 111-1. Therefore, the blocking layer may be etched faster than the bank 111-1, thereby forming an undercut structure 152 in the open structure 105B.

The blocking layer may comprise a metal or an inorganic material. The drawing number 124g may be a capping layer.

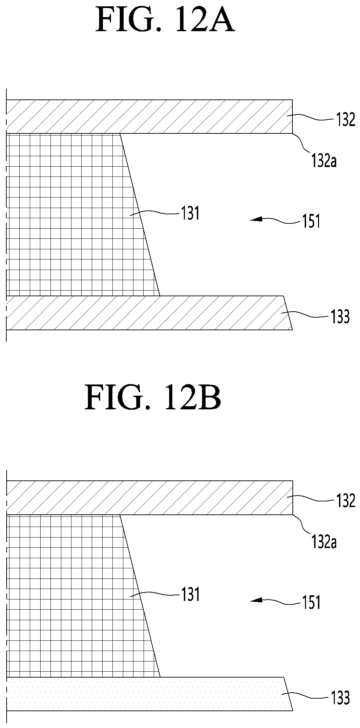

FIGS. 12A to 12G illustrate various protrusion parts.

As illustrated in FIG. 12A, the first layer 131, the second layer 132, and the third layer 133 may have different etch selectivity from each other.

The first layer 131 may comprise a metal having a high etch rate. The first layer 131 may comprise aluminum (Al), copper (Cu), or an alloy thereof. The second layer 132 and the third layer 133 may comprise the same material. The second layer 132 and the third layer 133 may each comprise a metal having an etching rate lower than that of the first layer 131. For example, the second layer 132 and the third layer 133 may each comprise titanium (Ti), molybdenum (Mo), molybdenum-titanium (MoTi), etc. The second layer 132 and the third layer 133 may each comprise a conductive oxide material having an etching rate lower than that of the first layer 131. For example, the second layer 132 and the third layer 133 may each comprise ITO, IZO, etc.

Since the second layer 132 and the third layer 133 comprise the same material, the etching selectivity of the material of the second layer 132 and the material of the third layer 133 may also be the same. In this instance, the side portion of the second layer 132 and the side portion of the third layer 133 may be positioned on a vertical line or a diagonal line, but are not limited thereto.

In FIG. 12A, the first layer 131, the second layer 132, and the third layer 133 may be auxiliary electrodes AC. In this instance, as illustrated in FIG. 10A, for electrical connection between the cathode electrode 123g and the auxiliary electrode AC, the second conductive layer 123-2 of the cathode electrode 123g is sufficient to be in contact with at least one or more layer of the first layer 131, the second layer 132, or the third layer 133.

As illustrated in FIG. 12B, the first layer 131, the second layer 132, and the third layer 133 may have different etching selectivity from each other.

The first layer 131 may comprise a metal having a high etch rate. The first layer 131 may comprise aluminum (Al), copper (Cu), or an alloy thereof.

The second layer 132 and the third layer 133 may comprise different materials. The second layer 132 may comprise a metal having an etch rate lower than that of the first layer 131. For example, the second layer 132 may comprise titanium (Ti), molybdenum (Mo), molybdenum-titanium (MoTi), etc. The second layer 132 may comprise a conductive oxide material having an etch rate lower than that of the first layer 131. For example, the second layer 132 may comprise ITO, IZO, etc. The third layer 133 may comprise an inorganic material having an etch rate lower than that of the first layer 131. For example, the third layer 133 may comprise silicon nitride (SiNx), silicon oxide (SiOx), silicon nitride (SiON), etc.

Since the second layer 132 and the third layer 133 comprise different materials from each other, the etching selectivity of the material of the second layer 132 and the material of the third layer 133 may be different, but is not limited thereto. In this instance, the side portion of the second layer 132 and the side portion of the third layer 133 may not be positioned on a vertical line. For example, the side portion of the third layer 133 may be formed to extend further in the direction of the adjacent subpixel than the side portion of the second layer 132, but is not limited thereto.

In FIG. 12B, the first layer 131 and the second layer 132 may be auxiliary electrodes AC. In this instance, as illustrated in FIG. 10A, for electrical connection between the cathode electrode 123g and the auxiliary electrode AC, the second conductive layer 123-2 of the cathode electrode 123g is sufficient to be in contact with at least one or more layer of the first layer 131 or the second layer 132. For example, the second conductive layer 123-2 may be in contact with the first layer 131 or the second layer 132 via the upper side of the third layer 133.

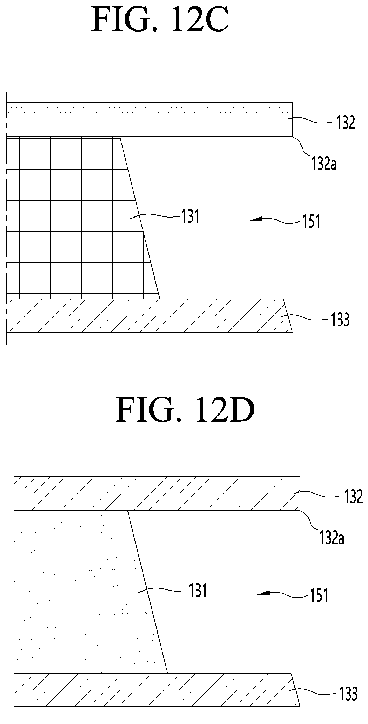

As illustrated in FIG. 12C, the first layer 131, the second layer 132, and the third layer 133 may have different etching selectivity from each other.

In FIG. 12C, the first layer 131 may comprise the same material as the first layer 131 illustrated in FIG. 12B. In FIG. 12C, the material of each of the second layer 132 and the third layer 133 may be opposite to the material of each of the second layer 132 and the third layer 133 illustrated in FIG. 12B. That is, in FIG. 12C, the second layer 132 may comprise an inorganic material having an etch rate lower than the etch rate of the first layer 131. In FIG. 12C, the third layer may comprise a metal or conductive oxide material having an etch rate lower than the etch rate of the first layer 131.

In FIG. 12C, the first layer 131 and the third layer 133 may be auxiliary electrodes AC. In this instance, as illustrated in FIG. 10A, for electrical connection between the cathode electrode 123g and the auxiliary electrode AC, the second conductive layer 123-2 of the cathode electrode 123g may be in contact with at least one or more layer of the first layer 131 or the third layer 132. For example, the second conductive layer 123-2 may be in contact with the upper side of the third layer 133 or the side portion of the first layer 131.

As illustrated in FIG. 12D, the first layer 131, the second layer 132, and the third layer 133 may have different etch selectivity from each other.

In FIG. 12D, the materials of the second layer 132 and the third layer 133 may be the same as the materials of the second layer 132 and the third layer 133 illustrated in FIG. 12A, respectively. In FIG. 12D, the first layer 131 may comprise a material having an etch rate greater than that of the second layer 132 or the third layer 133. For example, the first layer 131 may comprise silicon nitride (SiNx), silicon oxide (SiOx), silicon oxide nitride (SiON), etc.

In FIG. 12D, the second layer 132 and the third layer 133 may be auxiliary electrode AC. In this instance, as illustrated in FIG. 10A, for electrical connection between the cathode electrode 123g and the auxiliary electrode AC, the second conductive layer 123-2 of the cathode electrode 123g is sufficient to be in contact with at least one or more layer of the second layer 132 or the third layer 132. For example, the second conductive layer 123-2 is sufficient to be in contact with the upper side of the third layer 133 or the lower side of the second layer 131.

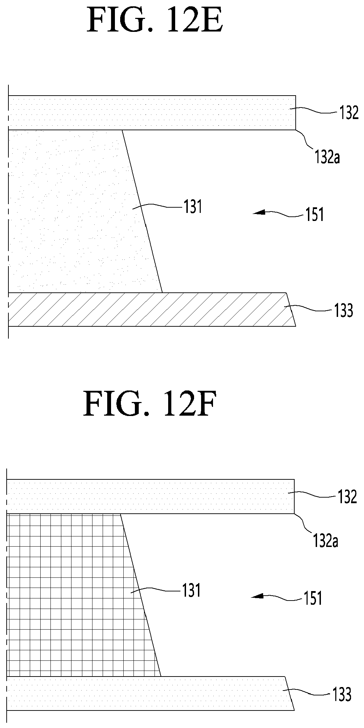

As illustrated in FIG. 12E, the first layer 131, the second layer 132, and the third layer 133 may have different etching selectivity from each other.

In FIG. 12E, the first layer 131 may comprise a material having a high etching rate, and the second layer 132 and the third layer 133 may comprise a material having a low etching rate. For example, the first layer 131 and the second layer 132 may comprise different inorganic materials from each other, and the third layer 133 may comprise a metal or a conductive oxide material.

In FIG. 12E, the third layer 133 may be an auxiliary electrode AC. In this instance, as illustrated in FIG. 10A, the second conductive layer 123-2 of the cathode electrode 123g may contact the third layer 132 for electrical connection between the cathode electrode 123g and the auxiliary electrode AC.

As illustrated in FIG. 12F, the first layer 131, the second layer 132, and the third layer 133 may have different etch selectivity from each other.

In FIG. 12F, the first layer 131 may comprise a material having a high etch rate, and the second layer 132 and the third layer 133 may comprise a material having a low etch rate. For example, the first layer 131 may comprise aluminum (Al), copper (Cu), or an alloy thereof. The second layer 132 and the third layer 133 may comprise silicon nitride (SiNx), silicon oxide (SiOx), silicon nitride (SiON), etc., respectively.

In FIG. 12F, the first layer 131 may be an auxiliary electrode AC. In this instance, as illustrated in FIG. 10A, the second conductive layer 123-2 of the cathode electrode 123g may contact the first layer 131 for electrical connection between the cathode electrode 123g and the auxiliary electrode AC.

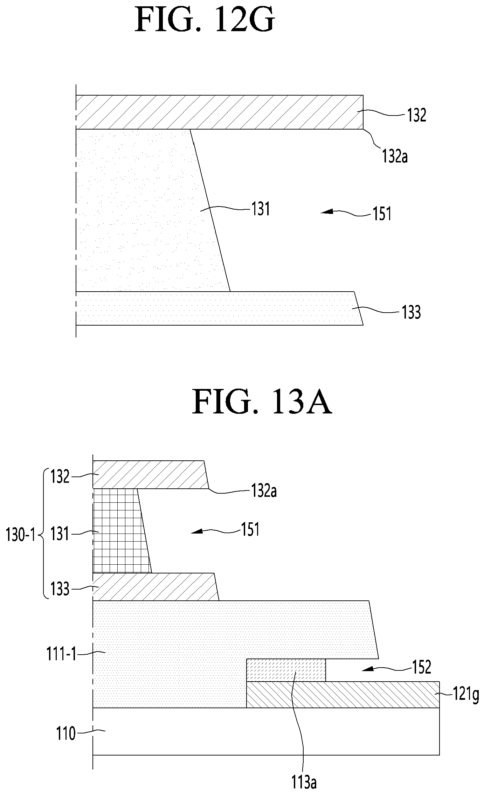

As illustrated in FIG. 12G, the first layer 131, the second layer 132, and the third layer 133 may have different etch selectivity from each other.

In FIG. 12G, the first layer 131 may comprise a material having a high etch rate, and the second layer 132 and the third layer 133 may comprise a material having a low etch rate. The first layer 131 and the third layer 133 may comprise different inorganic materials from each other. The second layer 132 may comprise a metal or a conductive oxide material.

In FIG. 12G, the second layer 132 may be an auxiliary electrode AC. In this instance, as illustrated in FIG. 10A, the second conductive layer 123-2 of the cathode electrode 123g may contact the lower side of the second layer 132 via the upper side of the third layer 133 and the side portion of the first layer 131 for electrical connection between the cathode electrode 123g and the auxiliary electrode AC.

FIGS. 13A to 13C show various placement positions of the open structure in the asymmetric open-connection structure according to the embodiment. Although the drawing illustrates the connection structure 105A and the open structure 105B of the first protrusion part 130-1 illustrated in FIG. 4A, the same may be applied to the connection structure 105A and the open structure 105B of the second protrusion part 130-2.

As illustrated in FIGS. 4A and 13A, the first bank 111-1 may be disposed on the substrate 110. The first bank 111-1 may be disposed on the substrate 110 between the red subpixel SPr and the green subpixel SPg.

The first protrusion part 130-1 may be disposed on the upper side of the first bank 111-1. The first protrusion part 130-1 may have the connection structure 105A. The first protrusion part 130-1 may comprise a first layer 131, a second layer 132 on the first layer 131, and a third layer 133 below the first layer 131. The third layer 133 may be omitted. Although not illustrated, a fourth layer may be disposed on the second layer 132. The fourth layer may serve as a stopper to prevent etching of the second layer 132, but is not limited thereto.

The first layer 131, the second layer 132, and the third layer 133 may comprise materials having different etching selectivity from each other. For example, since the etching rate of the first layer 131 is greater than the etching rate of the second layer 132 and/or the third layer 133, an undercut structure 151 may be formed in which the side portion of the first layer 131 is recessed into the inside of the first protrusion part 130-1 from the side portion of the second layer 132 or the side portion of the third layer 133.

At least one or more layer of the first layer 131, the second layer 132, or the third layer 133 may be an auxiliary electrode AC to which a cathode electrode is electrically connected. For example, a green organic light-emitting element comprising an anode electrode, a green organic light-emitting layer, and a cathode electrode may be disposed in a green subpixel.

The cathode electrode may extend from the green organic light-emitting layer in the direction of the first protrusion part 130-1 and be electrically connected to the auxiliary electrode AC.

Meanwhile, an open structure 105B may be disposed on the lower side of the edge region of the first bank 111-1. The open structure 105B may comprise at least one or more blocking layer 113a. An undercut structure 152 can be formed by at least one side of the blocking layer 113a which is recessed into the inside of the first bank 111-1 from the side of the first bank 111-1. By isolating some layers (layers made of low-resistance organic light-emitting materials) constituting the green organic light-emitting element, such as a hole injection layer, a first organic light-emitting stack, a charge generation layer, etc., an electrical short between an anode electrode and a cathode electrode in the green organic light-emitting element may be blocked, thereby preventing loss due to leakage current and poor image quality.

In an embodiment, the connection structure 105A may serve to connect the cathode electrode to the auxiliary electrode AC, and the open structure 105B may serve to block an electrical short between the anode electrode and the cathode electrode constituting the green organic light-emitting element. In this way, a structure comprising the connection structure 105A and the open structure 105B disposed around the first bank 111-1 may be called an asymmetric open-connection structure (105 of FIG. 4A).

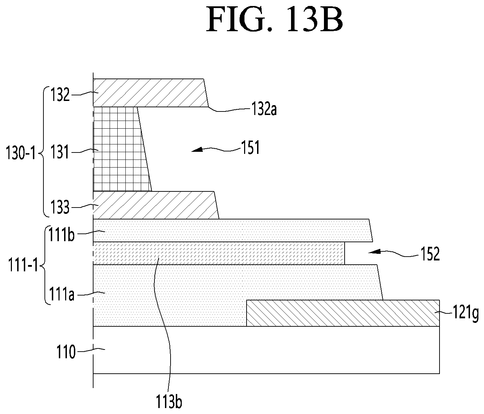

As illustrated in FIG. 13B, the blocking layer 113b included in the open structure 105B may be disposed inside the first bank 111-1.

The first bank 111-1 may comprise the first-first bank 111a and the first-2 bank 111b on the first-first bank 111a. The first-first bank 111a and the first-second bank 111b may comprise the same material, but are not limited thereto.

The blocking layer 113b may be disposed between the first-first bank 111a and the first-second bank 111b. The etching rate of the blocking layer 113b may be greater than the etching rates of the first-first bank 111a and/or the first-second bank 111b. When the first-first bank 111a, the first-second bank 111b, and the blocking layer 113b are etched, the side portion of the blocking layer 113b may be recessed into the inside of the first bank 111-1 from the side portion of the first-first bank 111a or the first-second bank 111b, thereby forming an undercut structure 152.

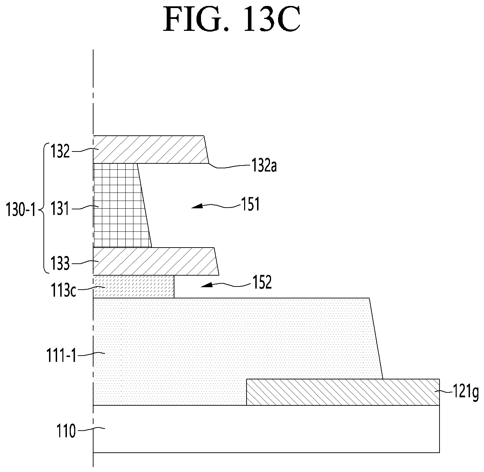

As illustrated in FIG. 13C, the blocking layer 113c of the open structure 105B may be disposed on the upper side of the first bank 111-1. For example, the blocking layer 113c may be disposed between the first bank 111-1 and the first layer 131 of the first protrusion part 130-1. When the third layer 133 is disposed under the first layer 131, the blocking layer 113c may be disposed between the first bank 111-1 and the third layer 133.

The blocking layer 113c may be one of the layers forming the first protrusion part 130-1. For example, the first protrusion part 130-1 may comprise a first layer 131, a second layer 132 on the first layer 131, a third layer 133 below the first layer 131, and a fourth layer (not illustrated) on the second layer 132. In this instance, the first protrusion part 130-1 may further comprise a fifth layer as a blocking layer 113c below the third layer 133.

The blocking layer 113c, the third layer 133, and the first bank 111-1 may have different etching selectivity.

The etching rate of the blocking layer 113c may be greater than the etching rate of the third layer 133 and/or the first bank 111-1. In this instance, an undercut structure 152 may be formed on the side portion of the blocking layer 113c which is recessed from the side portion of the third layer 133 and/or the first bank 111-1 into the inside of the first protrusion part 130-1.

The undercut structure 151 formed by the first layer 131 between the second layer 132 and the third layer in the first protrusion part 130-1 may be called the first undercut structure, and the undercut structure 152 formed by the blocking layer 113c between the third layer 133 and the first bank 111-1 may be called the second undercut structure, or vice versa.

The points to note according to the formation positions of the blocking layers 113a, 113b, and 113c are as follows.

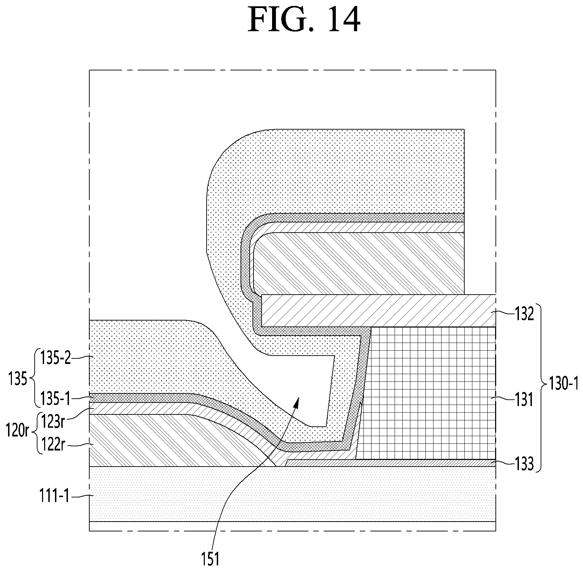

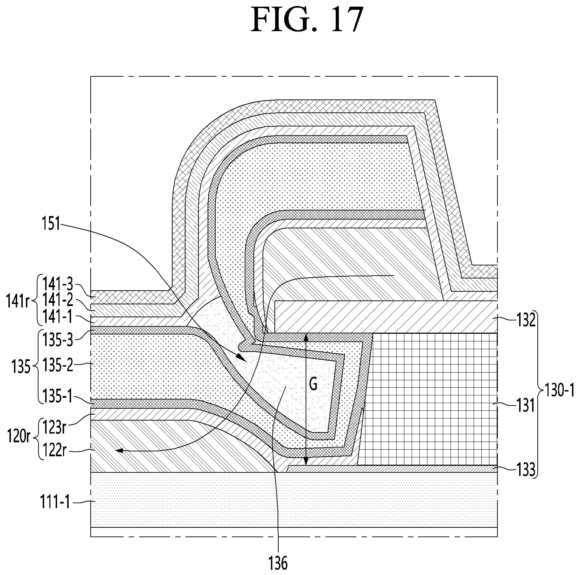

The thickness of the deposition films deposited on the open structure 105B may be deposited thinner than the thickness formed on the actual light-emitting portion depending on the deposition angle and the structure of the upper films of the open structure 105B and the installation position of the structure. For example, the thickness of the deposition film formed in the undercut structure 152 of the open structure 105B illustrated in FIG. 13C can be formed to be 30% or thinner than the thickness of the deposition film formed in the undercut structure 152 of the open structure 105B illustrated in FIG. 13A. This is because the thickness of the final deposited deposition film decreases as it gets closer to the first protrusion part 130-1 due to the shadow effect of the first protrusion part 130-1. Accordingly, the thickness of the blocking gap OG can be set based on a deposition simulation experiment and an actual deposition experiment in addition to a method of setting the thickness of the theoretical blocking gap calculated from the thickness of the organic light-emitting element 120r, 120g, and 120b for each color. The following sixth embodiment (FIG. 14) to ninth embodiment (FIG. 17) relate to a moisture penetration blocking structure, which will be described in detail with reference to FIGS. 14 to 17. In the description related to FIGS. 14 to 17, the same or similar drawing numbers previously illustrated are components having the same or similar shape, structure, and/or function, and thus, a detailed description thereof is omitted.

FIG. 14 is a cross-sectional view illustrating an organic light-emitting display device according to a sixth embodiment. Although the red subpixel SPr and the first bank 130-1 are illustrated in the drawing, the green subpixel SPg, the blue subpixel SPb, and other banks may also be applied in the same manner.

Referring to FIG. 14, the organic light-emitting display device according to the sixth embodiment may comprise a substrate 110, a first bank 111-1, a first protrusion part 130-1, a red organic light-emitting element 120r, an encapsulation layer 135, etc. Since the encapsulation layer 135 has a moisture penetration blocking structure, moisture, etc. may be blocked, thereby preventing the organic light-emitting element from being damaged by moisture, etc.

An organic light-emitting display device having a side-by-side structure in which a red subpixel SPr, a green subpixel SPg, and a blue subpixel SPb are sequentially formed using a photolithography process can be manufactured. A photolithography process comprising an exposure process and an etching process can be performed three times to sequentially form a red subpixel SPr, a green subpixel SPg, and a blue subpixel SPb. In this instance, an undercut structure 151, for example, a U-cave is a very important region for securing product yield and reliability. Therefore, an encapsulation layer 135 disposed on a red organic light-emitting layer 122r or a cathode electrode 123r using the undercut structure 151 needs to be provided with a structure that reliably blocks moisture, etc., i.e., a moisture penetration blocking structure. A red organic light-emitting element 120r can be configured by an anode electrode (not illustrated), a red organic light-emitting layer 122r, and a cathode electrode 123r.

In an embodiment, the encapsulation layer 135 may comprise a first-first insulating layer 135-1 and a first-second insulating layer 135-2 on the first-first insulating layer 135-1. For example, the first-first insulating layer 135-1 and the first-second insulating layer 135-2 may comprise different inorganic materials. For example, the first-first insulating layer 135-1 may comprise a silicon oxide-based material, and the first-second insulating layer 135-2 may comprise a silicon nitride-based material. For example, the first-first insulating layer 135-1 may comprise an inorganic material, and the first-second insulating layer 135-2 may comprise an organic material. Since the encapsulation layer 135 having a double structure of the first-first insulating layer 135-1 and the first-second insulating layer 135-2 is formed, moisture, etc., does not penetrate through the encapsulation layer 135 to the cathode electrode 123r or the red organic light-emitting element 120r.

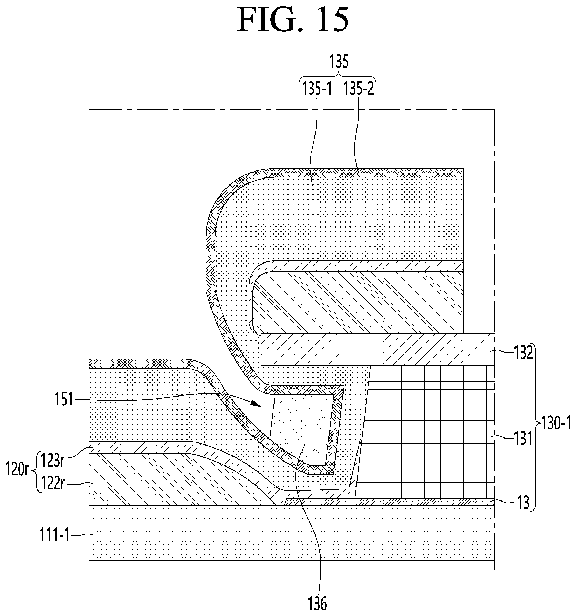

FIG. 15 is a cross-sectional view illustrating an organic light-emitting display device according to a seventh embodiment. In the drawing, a red subpixel SPr and a first bank 130-1 are illustrated, but the same may be applied to green subpixel SPg, blue subpixel SPb, and other banks.

Referring to FIG. 15, the organic light-emitting display device according to the seventh embodiment may comprise a substrate 110, a first bank 130-1, a first protrusion part 130-1, a red organic light-emitting element 120r, an encapsulation layer 135, etc. Since the encapsulation layer 135 has a moisture penetration blocking structure, moisture, etc. can be blocked, so that the organic light-emitting element can be prevented from being damaged by moisture, etc.

In the seventh embodiment (FIG. 15), the encapsulation layer 135 can have a double structure, similar to the sixth embodiment (FIG. 14). However, in the encapsulation layer 135 of the seventh embodiment (FIG. 15), the first-first insulating layer 135-1 and the first-second insulating layer 135-2 can comprise different inorganic materials. For example, the first-first insulating layer 135-1 can comprise a silicon nitride-based material, and the first-second insulating layer 135-2 can comprise a silicon oxide-based material. Since the encapsulation layer 135 having a double structure of the first-first insulating layer 135-1 and the first-second insulating layer 135-2 is formed, moisture, etc., does not penetrate through the encapsulation layer 135 to the cathode electrode 123r or the red organic light-emitting element 120r.

Meanwhile, the organic light-emitting display device according to the seventh embodiment may comprise a resin layer 136. The resin layer 136 may be formed inside the undercut structure 151. The resin layer 136 may be a residual film remaining from the organic film that is a component of the photosensitive pattern or the encapsulation layer 135 after an etching process is performed to form a red subpixel SPr, but is not limited thereto. The resin layer 136 may be comprised as a part of the encapsulation layer 135, but is not limited thereto.

More specifically, after the red organic light-emitting element 120r, etc. is deposited on the entire region of the substrate 110, the red organic light-emitting element 120r can be removed from the first bank 130-1 or the green subpixel SPg and the blue subpixel SPb by using a photosensitive pattern so that the red organic light-emitting element 120r remains only in the red subpixel SPr. Thereafter, the photosensitive pattern can be removed. The photosensitive pattern has high purity, low water vapor transmission rate (WVTR), etc., and can comprise a transparent resin material. Even if the photosensitive pattern removal process is performed, a part of the photosensitive pattern remains without being removed inside the undercut structure 151, so that it can be formed as a residual film as a resin layer 136.

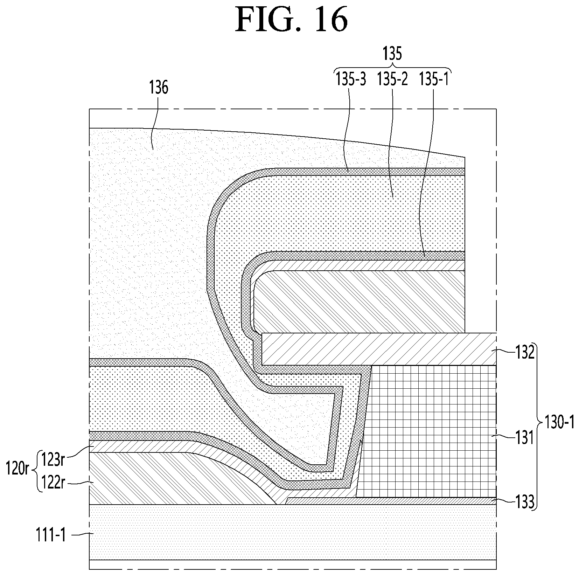

FIG. 16 is a cross-sectional view illustrating an organic light-emitting display device according to an eighth embodiment.

Although the red subpixel SPr and the first bank 130-1 are illustrated in the drawing, the green subpixel SPg, the blue subpixel SPb, and other banks may be applied in the same manner.

Referring to FIG. 16, the organic light-emitting display device according to the eighth embodiment may comprise a substrate 110, a first bank 130-1, a first protrusion part 130-1, a red organic light-emitting element 120r, an encapsulation layer 135, a resin layer 136, etc. The encapsulation layer 135 has a moisture penetration blocking structure, so that moisture, etc. may be blocked, thereby preventing the organic light-emitting element from being damaged by moisture, etc.

In the sixth embodiment (FIG. 14) and the seventh embodiment (FIG. 15), the encapsulation layer 135 having a double structure is provided, whereas in the eighth embodiment (FIG. 16), the encapsulation layer 135 may have a triple structure.

The encapsulation layer 135 may comprise a first-first insulating layer 135-1, a first-second insulating layer 135-2 on the first-first insulating layer 135-1, and a first-third insulating layer 135-3 on the first-second insulating layer 135-2. The first-first insulating layer 135-1, the first-second insulating layer 135-2, and the first-third insulating layer 135-3 may comprise different inorganic materials from each other. For example, the first-first insulating layer 135-1 and the first-third insulating layer 135-3 may comprise a silicon oxide-based material, and the first-second insulating layer 135-2 may comprise a silicon nitride-based material.

The resin layer 136 may be formed on the red subpixel SPr as well as inside the undercut structure 151.

As described above, a photosensitive pattern may be formed on the red subpixel SPr in order to remove the red organic light-emitting element 120r, etc. deposited on the green subpixel SPg and the blue subpixel SPb, excluding the red subpixel SPr. After the red organic light-emitting element 120r, etc. deposited on the green subpixel SPg and the blue subpixel SPb are removed using the photosensitive pattern, the photosensitive pattern is not removed, so that the resin layer 136 may be formed on the red subpixel SPr as well as inside the undercut structure 151. The resin layer 136 may be comprised as a part of the encapsulation layer 135, but is not limited thereto.

FIG. 17 is a cross-sectional view illustrating an organic light-emitting display device according to a ninth embodiment. The ninth embodiment is similar to the seventh embodiment (FIG. 15) or the eighth embodiment (FIG. 16) except for the second encapsulation layer 141r. In the ninth embodiment, components having the same shape, structure, and/or function as those of the seventh embodiment (FIG. 15) or the eighth embodiment (FIG. 16) are given the same drawing reference numerals, and detailed descriptions are omitted. Although the red subpixel SPr and the first bank 130-1 are illustrated in the drawing, the green subpixel SPg, the blue subpixel SPb, and other banks may also be applied in the same manner.

Referring to FIG. 17, an organic light-emitting display device according to the ninth embodiment may comprise a substrate 110, a first bank 130-1, a first protrusion part 130-1, a red organic light-emitting element 120r, a first encapsulation layer 135, a resin layer 136, a second encapsulation layer 141r, etc. Since the first encapsulation layer 135 and the second encapsulation layer 141r have a moisture penetration blocking structure, moisture, etc. are blocked, and thus the organic light-emitting element may be prevented from being damaged by moisture, etc.

A moisture penetration path (arrow) is illustrated in FIG. 17. That is, moisture can penetrate through the etched cross-section of the red organic light-emitting layer 122r formed on the first protrusion part 130-1 and the opening gap G of the undercut structure 151, move toward the anode electrode 121r of the red subpixel SPr, and penetrate along the organic light-emitting layer of the red subpixel SPr.

In order to more completely block this moisture penetration path (arrow), in the embodiment, a second encapsulation layer 141r can be disposed on the first encapsulation layer 135. The second encapsulation layer 141r can comprise a second-first insulating layer 141-1, a second-second insulating layer 141-2, a second-third insulating layer 141-3, etc. The second-first insulating layer 141-1, the second-second insulating layer 141-2, and the second-third insulating layer 141-3 may each comprise a photosensitive material. The second-first insulating layer 141-1, the second-second insulating layer 141-2, and the second-third insulating layer 141-3 may each comprise an inorganic material or an organic material.

Meanwhile, although not illustrated, during a photolithography process in which blue subpixels SPb, green subpixels SPg, and red subpixels SPr are formed in that order, three insulating layers may be provided as the second encapsulation layer on the first encapsulation layer 135 of the blue subpixel SPb, two insulating layers may be provided as the second encapsulation layer on the first encapsulation layer 135 of the green subpixel SPg, and one insulating layer may be provided as the second encapsulation layer on the first encapsulation layer 135 of the red subpixel SPr.

Since there is no need to form a separate undercut structure 151 after the red subpixel SPr is patterned, one insulating layer of the second encapsulation layer on the first encapsulation layer 135 of the red subpixel SPr can be used for pad opening of the non-display region NAA on the outside of the panel.

If one insulating layer is not used for pad opening of the non-display region NAA, two insulating layers are provided as the second encapsulation layer on the first encapsulation layer 135 of the blue subpixel SPb, one insulating layer is provided as the second encapsulation layer on the first encapsulation layer 135 of the green subpixel SPg, and no insulating layer may be provided on the first encapsulation layer of the red subpixel SPr.

Meanwhile, the first-first insulating layer 135-1 and the first-third insulating layer 135-3 of the first encapsulation layer 135 may be formed of an ALD process-based inorganic film having a water vapor transmission rate (WVTR) that is approximately 20 times better than that of a PECVD process-based inorganic film. Accordingly, a high-reliability product with dramatically enhanced moisture penetration blocking performance may be implemented. Such a high-reliability product may be applied to an organic light-emitting display device for vehicles or military applications that must be guaranteed for a long time in a high temperature/high humidity environment.

Although not illustrated, a polymer resin may be applied on the second-third insulating layer 141-3 of the second encapsulation layer 141r using an inkjet process to form a resin layer, and another encapsulation layer or another insulating layer comprising an inorganic material may be formed on the resin layer.

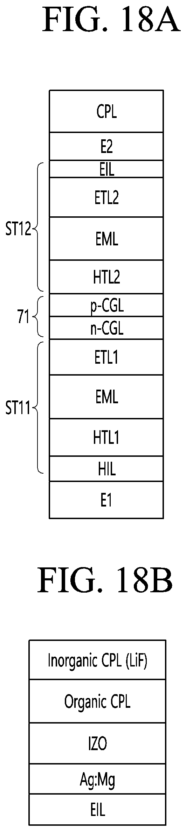

FIGS. 18A to 18D illustrate at least one or more layer additionally added between the electron injection layer and the cathode electrode of the second organic light-emitting stack.

As illustrated in FIG. 18A, a cathode electrode E2 may be formed on the electron injection layer EIL. As illustrated in FIG. 18B, a first conductive layer (123-1 of FIG. 10A) may be deposited on the electron injection layer EIL, and a second conductive layer 123-2 may be deposited on the first conductive layer 123-1 using a sputtering process. The cathode electrode E2 may be formed by the first conductive layer 123-1 and the second conductive layer 123-2.

The electron injection layer EIL may comprise Yb or Li, the first conductive layer 123-1 may comprise Mg:Ag, and the second conductive layer 123-2 may comprise ITO, IZO, etc. In this instance, the electron injection layer EIL or the first conductive layer 123-1 may be damaged by radicals from plasma during the sputtering process.

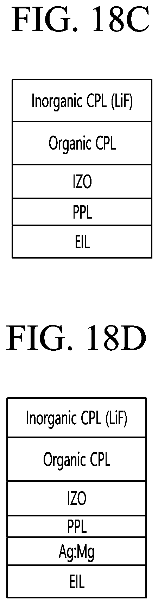

A plasma protection layer PPL may be formed on the electron injection layer EIL. As an example, as illustrated in FIG. 18C, the plasma protection layer PPL may be formed between the electron injection layer EIL and the first conductive layer 123-1 comprising Mg:Ag. As another example, as illustrated in FIG. 18D, the plasma protection layer PPL may be formed between the first conductive layer 123-1 comprising Mg:Ag and the second conductive layer 123-2 comprising IZO, etc.

When the properties of the material of the plasma protection layer PPL, such as refractive index, electrical conductivity, and transmittance, the type and amount of doping material, and the thickness of each layer are optimized, the luminescence efficiency of the organic light-emitting display device can be improved.

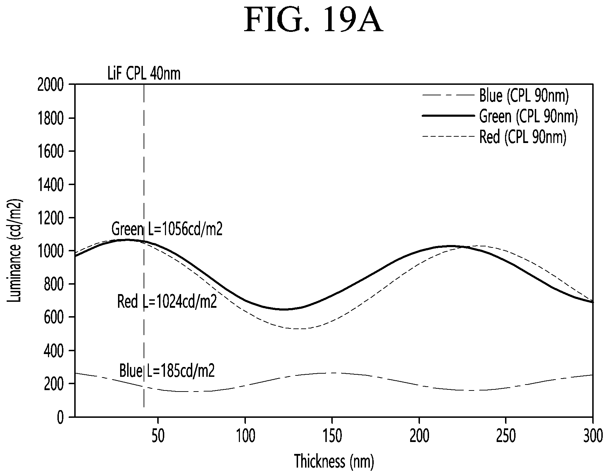

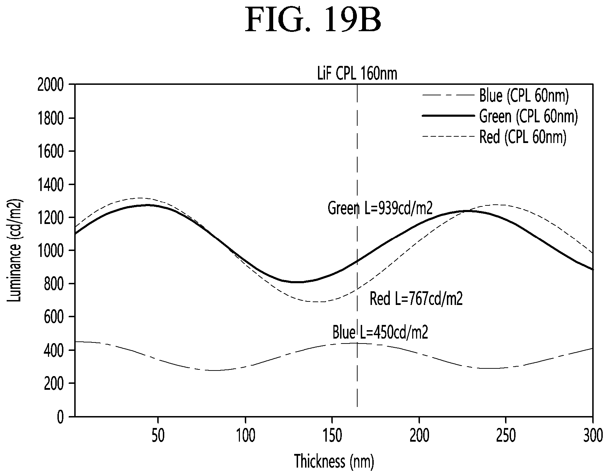

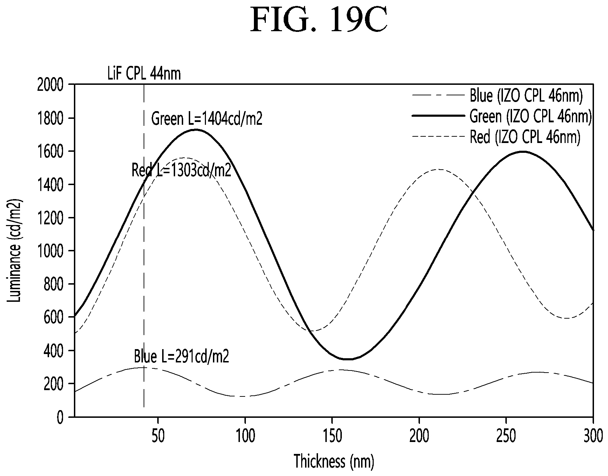

FIGS. 19A to 19C show simulated results of luminance according to the thickness of the capping layer comprising LiF according to the comparative example and the embodiment. FIGS. 19B and 19C illustrate the results of comparing the luminescence efficiency of the red organic light-emitting element 120r, the green organic light-emitting element 120g, and the blue organic light-emitting element 120b according to the thickness of each of the inorganic capping layer (LiF) and the organic capping layer illustrated in FIG. 18D with the luminescence efficiency in the comparative example (FIG. 19A).

In FIGS. 19A to 19C, the horizontal axis may represent the thickness of the inorganic capping layer, and the vertical axis may represent luminance.

In FIG. 19A, when the thickness of the inorganic capping layer is 40 nm, the luminance of the red organic light-emitting element 120r, the green organic light-emitting element 120g, and the blue organic light-emitting element 120b, each of which has an organic capping layer thickness of 90 nm, can be 1024 Cd/cm$^2$, 1056 Cd/cm$^2$, and 185 Cd/cm$^2$, respectively.

As illustrated in FIG. 19B, in a structure with an added plasma protection layer PPL, when the thickness of the inorganic capping layer is 160 nm, the luminance of the red organic light-emitting element 120r, the green organic light-emitting element 120g, and the blue organic light-emitting element 120b, each of which has an organic capping layer thickness of 60 nm, can be 767 Cd/cm$^2$, 939 Cd/cm$^2$, and 450 Cd/cm$^2$, respectively.

As illustrated in FIG. 19C, in a structure with an added plasma protection layer PPL, the thickness of the inorganic capping layer is 144 nm, and the luminance of the red organic light-emitting element 120r, the green organic light-emitting element 120g, and the blue organic light-emitting element 120b, each having a thickness of the organic capping layer of 46 nm, can be 1303 cd/cm$^2$, 1404 cd/cm$^2$, and 291 cd/cm$^2$, respectively.

As illustrated in FIGS. 19A to 19C, it can be seen that the luminance of the red organic light-emitting element 120r, the green organic light-emitting element 120g, and the blue organic light-emitting element 120b vary depending on the thickness of the inorganic capping layer.

Therefore, by optimizing the thickness of the inorganic capping layer and the thickness of the organic capping layer, the luminescence efficiency of each of the red organic light-emitting element 120r, the green organic light-emitting element 120g, and the blue organic light-emitting element 120b in the embodiment is much higher than that of the comparative example, so that the luminance can also be increased.

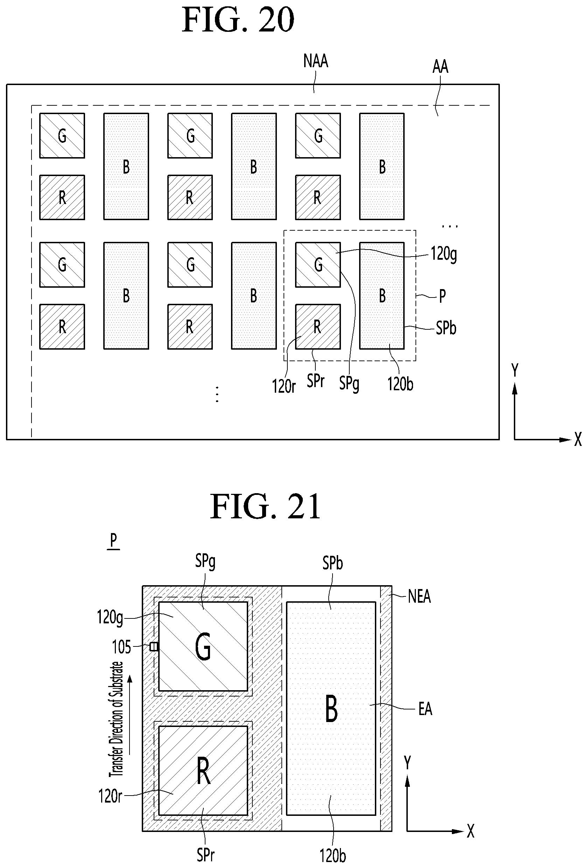

FIG. 20 is a plan view schematically illustrating an organic light-emitting display device according to the second embodiment. FIG. 21 is a plan view illustrating one pixel of FIG. 20. In the drawing, it may be illustrated that the substrate 110 is transported along the second direction Y, but is not limited thereto.

As described above, in the first embodiment (FIGS. 1 and 2), the red organic light-emitting element 120r, the green organic light-emitting element 120g, and the blue organic light-emitting element 120b can be disposed in a stripe shape along the second direction Y.

In contrast, as illustrated in FIGS. 20 and 21, in the second embodiment, the red organic light-emitting element 120r, the green organic light-emitting element 120g, and the blue organic light-emitting element 120b may be disposed in a dot shape and spaced apart from each other. The red organic light-emitting element 120r may be disposed in the red subpixel SPr, the green organic light-emitting element 120g may be disposed in the green subpixel SPg, and the blue organic light-emitting element 120b may be disposed in the blue subpixel SPb. One pixel P may be configured by the red subpixel SPr, the green subpixel SPg, and the blue subpixel SPb.

For example, the red organic light-emitting element 120r and the green organic light-emitting element 120g may be isolated by one row line along the second direction Y, respectively. For example, the blue organic light-emitting element 120b may be isolated by two row lines along the second direction Y.

For example, the area of the blue organic light-emitting element 120b may be greater than the area of the red organic light-emitting element 120r or the red organic light-emitting element 120r. The length of the blue organic light-emitting element 120b in the second direction Y may be similar to the sum of the width of the red organic light-emitting element 120r and the width of the green organic light-emitting element 120g, but is not limited thereto.

Meanwhile, in the pixel structure illustrated in FIGS. 20 and 21, there is no connection structure (105A of FIG. 4A) between adjacent subpixels along the first direction X, but an asymmetric open-connection structure 105, i.e., a connection structure 105A and an open structure 105B, may be provided at least two or more edges of each of the subpixels SPr, SPg, and SPb along the second direction Y.

**Claims**

1.  An organic light-emitting display device, comprising:

    a bank between subpixels on a substrate;
    an anode electrode in the subpixel;
    an organic light-emitting layer disposed on the anode electrode and the bank, and comprising a hole injection layer;
    a cathode electrode disposed on the organic light-emitting layer and being in contact with an end of the hole injection layer; and
    an open structure in an edge region of the bank,
    wherein the organic light-emitting layer has a separation structure corresponding to the open structure, and
    wherein the hole injection layer is configured to be isolated in the separation structure.

2.  The organic light-emitting display device of claim 1, wherein the open structure comprises:
    at least one or more blocking layer which is inwardly recessed from a side portion of the bank.

3.  The organic light-emitting display device of claim 2, wherein the open structure has an undercut structure having a blocking gap corresponding to a width of the blocking layer, and
    wherein a margin of the blocking gap is set between a distance between a cathode electrode and a second organic light-emitting stack in a red organic light-emitting element having the largest thickness and a distance between an anode electrode and a cathode electrode in a blue organic light-emitting element having the smallest thickness.

4.  The organic light-emitting display device of claim 3, wherein a thickness of the blocking gap is set based on a deposition simulation experiment and an actual deposition experiment based on a method of setting the blocking gap calculated from a thickness of the organic light-emitting element for each color.

5.  The organic light-emitting display device of claim 1, wherein the organic light-emitting layer comprises:

    a first organic light-emitting stack between the hole injection layer and a charge generation layer; and
    a second organic light-emitting stack between the charge generation layer and the cathode electrode, and
    wherein the cathode electrode is configured to be in contact with an end of the charge generation layer.

6.  The organic light-emitting display device of claim 5, wherein the first organic light-emitting stack and the charge generation layer are isolated in the separation structure.

7.  The organic light-emitting display device of claim 1, wherein the cathode electrode comprises at least one of a first conductive layer or a second conductive layer, and

    wherein the first conductive layer comprises a Mg:Ag alloy, and
    wherein the second conductive layer comprises a conductive oxide material.

8.  The organic light-emitting display device of claim 7, further comprising:

    a protrusion part on an upper side of the bank,
    wherein the protrusion part has a connection structure comprising an auxiliary electrode electrically connected to the cathode electrode,
    wherein the protrusion part comprises:

        a first layer; and
        a second layer on the first layer, and
        wherein the connection structure has an undercut structure in which is recessed from a side portion of the second layer into the inside of the protrusion part.

9.  The organic light-emitting display device of claim 8, wherein the second conductive layer is disposed on the first conductive layer,

    wherein the first conductive layer is disposed on the organic light-emitting layer, and

wherein the second conductive layer is configured to be in contact with a side portion of the first layer and a lower side of the second layer.

10. The organic light-emitting display device of claim 8, wherein the protrusion part further comprises:

a third layer below the first layer, and
wherein a side portion of the third layer is positioned on the same line as the side portion of the second layer or extends in a direction of the subpixel from the side portion of the second layer.

11. The organic light-emitting display device of claim 10, wherein at least one of the first layer, the second layer or the third layer is the auxiliary electrode.

12. The organic light-emitting display device of claim 10, wherein the hole injection layer is disposed on the third layer, and wherein the first conductive layer is configured to be in contact with the end of the hole injection layer and an upper side of the third layer.

13. The organic light-emitting display device of claim 10, wherein the second conductive layer is disposed on the first conductive layer,

wherein the first conductive layer is disposed on the organic light-emitting layer, and
wherein the second conductive layer is configured to be in contact with the side portion of the first layer, the lower side of the second layer, the end of the hole injection layer and an upper side of the third layer.

14. The organic light-emitting display device of claim 10, wherein the protrusion part further comprises:
a fourth layer on the second layer.

# FIG. 1

# FIG. 2

# FIG. 3

# FIG. 4A

# FIG. 4B

# FIG. 4C

140r

135

123r
122r  120r
121r

125-1  110  111-3

C  C'

# FIG. 5

# FIG. 6

# FIG. 7

132a

141g { 141-3
       141-2

134

130-1 { 132
        131

135-2 } 135
135-1

111-1

123-2 } 123g
123-1        } 120g
122g
121g

110

105A    151    113

105B    152    125-2

# FIG. 8A

# FIG. 8B

# FIG. 8C

# FIG. 9

# FIG. 10A

EIL/ETL, EML, HTL
CGL, HIL, E2

θc, θo

134
132
131
133
130-1
111-1
110

105A
132a
151
152
113
105B
125-2

123-2
123-1
123g
122g
121g
120g

# FIG. 10B

105A

151

131

123-2
123-1 }123g

122-4
122-3
122-2 }122g
122-1

133

# FIG. 10C

105B

111-1

123-2
123-1 }123g

122-4
122-3
122-2 }122g
122-1

120g

121g

113

OD

OG

110

152     125-1

# FIG. 11

# FIG. 12A

# FIG. 12B

# FIG. 12C

132
132a
131
151
133

# FIG. 12D

132
132a
131
151
133

# FIG. 12E

# FIG. 12F

# FIG. 12G

132
132a
131
151
133

# FIG. 13A

132
132a
151
130-1
131
133
111-1
152
121g
110
113a

## FIG. 13B

# FIG. 13C

# FIG. 14

# FIG. 15

# FIG. 16

# FIG. 17

# FIG. 18A

| | |
|---|---|
| | CPL |
| | E2 |
| ST12 | EIL |
| | ETL2 |
| | EML |
| | HTL2 |
| 71 | p-CGL |
| | n-CGL |
| ST11 | ETL1 |
| | EML |
| | HTL1 |
| | HIL |
| | E1 |

# FIG. 18B

| |
|---|
| Inorganic CPL (LiF) |
| Organic CPL |
| IZO |
| Ag:Mg |
| EIL |

# FIG. 18C

| Inorganic CPL (LiF) |
| :---: |
| Organic CPL |
| IZO |
| PPL |
| EIL |

# FIG. 18D

| Inorganic CPL (LiF) |
| :---: |
| Organic CPL |
| IZO |
| PPL |
| Ag:Mg |
| EIL |

# FIG. 19A

# FIG. 19B

# FIG. 19C

# FIG. 20

# FIG. 21

## INTERNATIONAL SEARCH REPORT

| International application No. |
| --- |
| **PCT/KR2024/011446** |

| A. | CLASSIFICATION OF SUBJECT MATTER |
| --- | --- |

**H10K 59/121**(2023.01)i; **H10K 71/20**(2023.01)i; **H10K 59/122**(2023.01)i; **H10K 59/35**(2023.01)i; **H10K 59/80**(2023.01)i; **H10K 59/12**(2023.01)i

According to International Patent Classification (IPC) or to both national classification and IPC

| B. | FIELDS SEARCHED |
| --- | --- |

Minimum documentation searched (classification system followed by classification symbols)

H10K 59/121(2023.01); H01L 27/32(2006.01); H01L 51/50(2006.01); H01L 51/56(2006.01); H05B 33/12(2006.01); H10K 50/15(2023.01)

Documentation searched other than minimum documentation to the extent that such documents are included in the fields searched

Korean utility models and applications for utility models: IPC as above
Japanese utility models and applications for utility models: IPC as above

Electronic data base consulted during the international search (name of data base and, where practicable, search terms used)

eKOMPASS (KIPO internal) & keywords: 유기 발광 표시 장치(organic light emitting display device), 유기 발광층(organic light emitting layer), 뱅크(bank), 정공 주입층(hole injection layer), 캐소드 전극(cathode), 분리 구조(separation structure), 단절(cut)

| C. | DOCUMENTS CONSIDERED TO BE RELEVANT |
| --- | --- |

| Category* | Citation of document, with indication, where appropriate, of the relevant passages | Relevant to claim No. |
| --- | --- | --- |
| Y | JP 2014-082132 A (SEMICONDUCTOR ENERGY LAB CO., LTD. et al.) 08 May 2014 (2014-05-08)<br>See paragraphs [0038]-[0092] and [0142]-[0153]; and figures 1-3 and 11. | 1-14 |
| Y | KR 10-2023-0061468 A (APPLIED MATERIALS, INC.) 08 May 2023 (2023-05-08)<br>See paragraphs [0017]-[0020] and [0027]-[0030]; and figure 2. | 1-14 |
| A | KR 10-2019-0122073 A (LG DISPLAY CO., LTD.) 29 October 2019 (2019-10-29)<br>See paragraphs [0060]-[0095] and [0177]; and figures 5 and 10. | 1-14 |
| A | KR 10-2015-0141338 A (LG DISPLAY CO., LTD.) 18 December 2015 (2015-12-18)<br>See paragraphs [0032]-[0065]; and figures 1-3. | 1-14 |
| A | KR 10-2295549 B1 (LG DISPLAY CO., LTD.) 27 August 2021 (2021-08-27)<br>See paragraphs [0049]-[0064]; and figure 1. | 1-14 |

☐ Further documents are listed in the continuation of Box C.　☑ See patent family annex.

| | |
| --- | --- |
| * Special categories of cited documents:<br>"A" document defining the general state of the art which is not considered to be of particular relevance<br>"D" document cited by the applicant in the international application<br>"E" earlier application or patent but published on or after the international filing date<br>"L" document which may throw doubts on priority claim(s) or which is cited to establish the publication date of another citation or other special reason (as specified)<br>"O" document referring to an oral disclosure, use, exhibition or other means<br>"P" document published prior to the international filing date but later than the priority date claimed | "T" later document published after the international filing date or priority date and not in conflict with the application but cited to understand the principle or theory underlying the invention<br>"X" document of particular relevance; the claimed invention cannot be considered novel or cannot be considered to involve an inventive step when the document is taken alone<br>"Y" document of particular relevance; the claimed invention cannot be considered to involve an inventive step when the document is combined with one or more other such documents, such combination being obvious to a person skilled in the art<br>"&" document member of the same patent family |

| Date of the actual completion of the international search | Date of mailing of the international search report |
| --- | --- |
| **28 October 2024** | **28 October 2024** |

| Name and mailing address of the ISA/KR | Authorized officer |
| --- | --- |
| **Korean Intellectual Property Office**<br>**Government Complex-Daejeon Building 4, 189 Cheongsa-ro, Seo-gu, Daejeon 35208** | |
| Facsimile No. **+82-42-481-8578** | Telephone No. |

Form PCT/ISA/210 (second sheet) (July 2022)

**INTERNATIONAL SEARCH REPORT**
Information on patent family members

International application No.

**PCT/KR2024/011446**

| Patent document cited in search report | | | Publication date (day/month/year) | Patent family member(s) | | | Publication date (day/month/year) |
|---|---|---|---|---|---|---|---|
| JP | 2014-082132 | A | 08 May 2014 | CN | 103779470 | A | 07 May 2014 |
| | | | | CN | 103779470 | B | 23 March 2018 |
| | | | | JP | 6204012 | B2 | 27 September 2017 |
| | | | | US | 2014-0103385 | A1 | 17 April 2014 |
| | | | | US | 9728693 | B2 | 08 August 2017 |
| KR | 10-2023-0061468 | A | 08 May 2023 | CN | 114514626 | A | 17 May 2022 |
| | | | | CN | 114514626 | B | 02 April 2024 |
| | | | | CN | 116058108 | A | 02 May 2023 |
| | | | | CN | 117580387 | A | 20 February 2024 |
| | | | | CN | 118317625 | A | 09 July 2024 |
| | | | | EP | 4208905 | A1 | 12 July 2023 |
| | | | | JP | 2023-540317 | A | 22 September 2023 |
| | | | | US | 11476313 | B2 | 18 October 2022 |
| | | | | US | 11610952 | B2 | 21 March 2023 |
| | | | | US | 11690254 | B2 | 27 June 2023 |
| | | | | US | 11690255 | B2 | 27 June 2023 |
| | | | | US | 11910657 | B2 | 20 February 2024 |
| | | | | US | 2022-0077251 | A1 | 10 March 2022 |
| | | | | US | 2022-0077252 | A1 | 10 March 2022 |
| | | | | US | 2022-0077257 | A1 | 10 March 2022 |
| | | | | US | 2023-0061457 | A1 | 02 March 2023 |
| | | | | US | 2023-0076050 | A1 | 09 March 2023 |
| | | | | US | 2023-0284484 | A1 | 07 September 2023 |
| | | | | US | 2023-0345771 | A1 | 26 October 2023 |
| | | | | US | 2024-0164149 | A1 | 16 May 2024 |
| | | | | WO | 2022-050983 | A1 | 10 March 2022 |
| | | | | WO | 2022-050984 | A1 | 10 March 2022 |
| KR | 10-2019-0122073 | A | 29 October 2019 | CN | 110391343 | A | 29 October 2019 |
| | | | | CN | 110391343 | B | 10 May 2022 |
| | | | | KR | 10-2248402 | B1 | 04 May 2021 |
| | | | | US | 11205685 | B2 | 21 December 2021 |
| | | | | US | 2019-0326372 | A1 | 24 October 2019 |
| KR | 10-2015-0141338 | A | 18 December 2015 | CN | 105280676 | A | 27 January 2016 |
| | | | | CN | 105280676 | B | 16 October 2018 |
| | | | | EP | 2955766 | A1 | 16 December 2015 |
| | | | | EP | 2955766 | B1 | 10 November 2021 |
| | | | | US | 2015-0357388 | A1 | 10 December 2015 |
| | | | | US | 2017-0309693 | A1 | 26 October 2017 |
| | | | | US | 9735212 | B2 | 15 August 2017 |
| KR | 10-2295549 | B1 | 27 August 2021 | CN | 105633297 | A | 01 June 2016 |
| | | | | CN | 105633297 | B | 20 April 2018 |
| | | | | EP | 3026725 | A1 | 01 June 2016 |
| | | | | EP | 3026725 | B1 | 06 November 2019 |
| | | | | KR | 10-2016-0062661 | A | 02 June 2016 |
| | | | | KR | 10-2016-0066288 | A | 10 June 2016 |
| | | | | KR | 10-2411565 | B1 | 22 June 2022 |
| | | | | US | 2016-0149156 | A1 | 26 May 2016 |
| | | | | US | 9748512 | B2 | 29 August 2017 |

Form PCT/ISA/210 (patent family annex) (July 2022)